(19) Europäisches Patentamt / European Patent Office / Office européen des brevets

(11) **EP 4 625 909 A1**

(12) **EUROPEAN PATENT APPLICATION**
published in accordance with Art. 153(4) EPC

(43) Date of publication:
**01.10.2025 Bulletin 2025/40**

(21) Application number: **22968139.0**

(22) Date of filing: **14.12.2022**

(51) International Patent Classification (IPC):
*H04L 27/00* (2006.01)     *H04L 1/00* (2006.01)
*H03M 13/11* (2006.01)

(52) Cooperative Patent Classification (CPC):
**H03M 13/11; H04L 1/00; H04L 27/00**

(86) International application number:
**PCT/CN2022/138944**

(87) International publication number:
**WO 2024/124428 (20.06.2024 Gazette 2024/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
  • **LIU, Ke
    Shenzhen, Guangdong 518129 (CN)**

  • **TONG, Jiajie
    Shenzhen, Guangdong 518129 (CN)**
  • **ZHANG, Huazi
    Shenzhen, Guangdong 518129 (CN)**
  • **WANG, Xianbin
    Shenzhen, Guangdong 518129 (CN)**
  • **WANG, Jun
    Shenzhen, Guangdong 518129 (CN)**

(74) Representative: **Pfenning, Meinig & Partner mbB
Patent- und Rechtsanwälte
Theresienhöhe 11a
80339 München (DE)**

(54) **CODING METHOD, DECODING METHOD, AND APPARATUS**

(57) An encoding method, a decoding method, and an apparatus are provided. A transmit end obtains a first bit sequence, performs LDPC encoding on the first bit sequence based on a check matrix, to obtain a second bit sequence, and outputs the second bit sequence. Correspondingly, a receive end receives to-be-decoded information of the second bit sequence, and performs LDPC decoding on the to-be-decoded information of the second bit sequence based on the check matrix, to obtain Ki information bits. The check matrix is determined based on a correspondence of a first information column and a first base graph, and a quantity of columns in the first information column is determined based on the quantity Ki of information bits and a quantity K of information columns in the first base graph. The technical solutions provided in this application can effectively increase a code rate.

Transmit end

**401** Obtain a first bit sequence, where the first bit sequence includes $K_1$ information bits, and $K_1$ is a positive integer

**402** Perform LDPC encoding on the first bit sequence based on a check matrix, to obtain a second bit sequence, where the check matrix is determined based on a correspondence of a first information column and a first base graph, and a quantity of columns in the first information column is determined based on a quantity $K_1$ of information bits and a quantity K of information columns in the first base graph

**403** Output the second bit sequence

**404** Perform rate matching on the second bit sequence

**405** Symbol sequence obtained by performing rate matching on the second bit sequence

Receive end

**406** Obtain to-be-decoded information of the second bit sequence, and perform LDPC decoding on the to-be-decoded information of the second bit sequence based on the check matrix, to obtain the $K_1$ information bits

FIG. 4

EP 4 625 909 A1

**Description**

**TECHNICAL FIELD**

This application relates to the field of communication technologies, and in particular, to an encoding method, a decoding method, and an apparatus.

**BACKGROUND**

A low-density parity-check (low-density parity-check, LDPC) code is a channel coding scheme that approaches a Shannon line, and has features such as good performance and low complexity. Currently, the low-density parity-check code has been determined by the 3rd Generation Partnership Project (3rd generation partnership project, 3GPP) as a 5th generation (5th generation, 5G) data channel coding scheme.

A maximum used code rate specified in a 5G data channel modulation and coding scheme (modulation and coding scheme, MCS) table is 0.926. When channel quality is good, a high MCS may be actually used in a communication system, and a higher MCS may be used in a future 6G scenario. Even if a code rate that can be supported by a base graph (base graph, BG) 1 in LDPC is 0.916, the code rate is still less than a specified maximum code rate.

Therefore, how to increase an encoding code rate of the LDPC code needs to be urgently resolved.

**SUMMARY**

Embodiments of this application provide an encoding method, a decoding method, and an apparatus, to effectively increase a code rate of LDPC encoding.

According to a first aspect, an embodiment of this application provides an encoding method. The method includes:

obtaining a first bit sequence, where the first bit sequence includes Ki information bits, and Ki is a positive integer; performing LDPC encoding on the first bit sequence based on a check matrix, to obtain a second bit sequence, where the check matrix is determined based on a correspondence of a first information column and a first base graph, and a quantity of columns in the first information column is determined based on a quantity Ki of information bits and a quantity K of information columns in the first base graph; and outputting the second bit sequence.

According to a method for determining a check matrix by newly adding an information column provided in this embodiment of this application, a code rate of LDPC encoding can be effectively increased. For example, a maximum code rate supported by a base graph (base graph, BG) in LDPC is $R_0$. Encoding is performed by using the method provided in this embodiment of this application, an encoding code rate (which may also be referred to as a target code rate) may be greater than $R_0$.

With reference to the first aspect, in a possible implementation, the method further includes:

performing rate matching on the second bit sequence, where a shortened information bit includes at least one of an information bit corresponding to the first information column and an information bit corresponding to an information column in the first base graph, and a punctured information bit includes at least one of an information bit corresponding to the first information column and an information bit corresponding to an information column in the first base graph.

According to a second aspect, an embodiment of this application provides a decoding method. The method includes:

obtaining to-be-decoded information of a second bit sequence, where the to-be-decoded information of the second bit sequence carries Ki information bits; and performing low-density parity-check LDPC decoding on the to-be-decoded information of the second bit sequence based on a check matrix, to obtain the Ki information bits, where the check matrix is determined based on a correspondence of a first information column and a first base graph, and a quantity of columns in the first information column is determined based on the quantity Ki of information bits and a quantity K of information columns in the first base graph.

Generally, two communication parties can learn of a target code rate and a target code length.

With reference to the first aspect or the second aspect, in a possible implementation, that the quantity of columns in the first information column is determined based on the quantity Ki of information bits and the quantity K of information columns in the first base graph includes: The quantity of columns in the first information column is determined based on the quantity Ki of information bits, the quantity K of information columns in the first base graph, and the target code rate.

For example, when the target code rate is greater than the maximum code rate $R_0$ supported by the first base graph, the quantity of columns in the first information column is related to $K_1$, K, and the target code rate. For example, when the target code rate is less than or equal to $R_0$, the quantity of columns in the first information column may be 0. Therefore, the quantity of columns in the first information column can be effectively determined based on the target code rate, K, and $K_1$, to ensure validity of the quantity of columns in the first information column.

With reference to the first aspect or the second aspect, in a possible implementation, the quantity $K_e$ of columns in the first information column is a nonnegative integer satisfying the following formula:

$$\frac{K+K_e}{N+K_e-P} \geq \frac{K_1}{N_1},$$

where

N is a total quantity of information columns and core check columns that correspond to a maximum code rate $R_0$ supported by the first base graph, P is a quantity of punctured columns in the first base graph, and $N_1$ is a target code length.

In embodiments of this application, when the target code rate is higher than the maximum code rate supported by the first base graph, achieving of the target code rate can be effectively ensured by newly adding an information column to the first base graph.

With reference to the first aspect or the second aspect, in a possible implementation, that the quantity of columns in the first information column is determined based on the quantity Ki of information bits and the quantity K of information columns in the first base graph includes: The quantity of columns in the first information column is determined based on the quantity Ki of information bits, the quantity K of information columns in the first base graph, and a lifting size of the check matrix.

For example, the lifting size of the check matrix may be related to the quantity of columns in the first information column. Therefore, when the target code length is not a product of the lifting size and the information column, a quantity of shortened bits can be effectively reduced by newly adding an information column.

With reference to the first aspect or the second aspect, in a possible implementation, the quantity $K_e$ of columns in the first information column is a nonnegative integer satisfying the following formula:

$$(K + K_e)Z_c^{K_e} - K_1 \geq 0,$$

where

$Z_c^{K_e}$ is the lifting size of the check matrix.

With reference to the first aspect or the second aspect, in a possible implementation, that the check matrix is determined based on the correspondence of the first information column and the first base graph includes: The check matrix is determined based on the correspondence of the first information column, the first base graph, and indication information, where the indication information indicates to change a value of at least one node in the first base graph.

In embodiments of this application, an LDPC code at a high code rate is constructed by using the correspondence of the first information column and the indication information, so that a better edge density can be obtained, and it is ensured that there is a performance gain in a case of a high code rate and there is no performance loss in a case of a low code rate.

With reference to the first aspect or the second aspect, in a possible implementation, the indication information is determined based on the target code rate.

With reference to the first aspect or the second aspect, in a possible implementation, the indication information is determined based on a reliability order, and the reliability order is determined based on a decoding threshold.

With reference to the first aspect or the second aspect, in a possible implementation, the indication information does not include a value corresponding to a variable node of an extended part whose degree is 1 in the first base graph.

With reference to the first aspect or the second aspect, in a possible implementation, a retransmission start position is determined based on at least one of the target code rate and the quantity of columns in the first information column.

With reference to the first aspect or the second aspect, in a possible implementation, the correspondence of the first information column includes a relationship between a column index in the first information column, a row index in the first information column, and a shift value.

With reference to the first aspect or the second aspect, in a possible implementation, the first information column includes a punctured column.

With reference to the first aspect or the second aspect, in a possible implementation, the second bit sequence includes encoded bits corresponding to the punctured column in the first information column.

According to a third aspect, an embodiment of this application provides a communication apparatus, configured to perform the method according to any one of the first aspect or the possible implementations of the first aspect. The communication apparatus includes units that perform the method according to any one of the first aspect or the possible implementations of the first aspect. For example, the communication apparatus may include a processing unit and a transceiver unit.

According to a fourth aspect, an embodiment of this application provides a communication apparatus, configured to perform the method according to any one of the second aspect or the possible implementations of the second aspect. The communication apparatus includes units that perform the method according to any one of the second aspect or the possible implementations of the second aspect. For example, the communication apparatus may include a processing unit and a transceiver unit.

According to a fifth aspect, an embodiment of this application provides a communication apparatus. The communication apparatus includes a processor, configured to perform the method according to any one of the first aspect or the possible implementations of the first aspect. Alternatively, the processor is configured to execute a program stored in a memory. When the program is executed, the method according to any one of the first aspect or the possible implementations of the first aspect is performed.

In a possible implementation, the memory is located outside the communication apparatus.

In a possible implementation, the memory is located inside the communication apparatus.

In embodiments of this application, the processor and the memory may alternatively be integrated into one component. In other words, the processor and the memory may alternatively be integrated together.

In a possible implementation, the communication apparatus further includes a transceiver. The transceiver is configured to receive a signal and/or send a signal.

According to a sixth aspect, an embodiment of this application provides a communication apparatus. The communication apparatus includes a processor, configured to perform the method according to any one of the second aspect or the possible implementations of the second aspect. Alternatively, the processor is configured to execute a program stored in a memory. When the program is executed, the method according to any one of the second aspect or the possible implementations of the second aspect is performed.

In a possible implementation, the memory is located outside the communication apparatus.

In a possible implementation, the memory is located inside the communication apparatus.

In embodiments of this application, the processor and the memory may alternatively be integrated into one component. In other words, the processor and the memory may alternatively be integrated together.

In a possible implementation, the communication apparatus further includes a transceiver. The transceiver is configured to receive a signal and/or send a signal.

According to a seventh aspect, an embodiment of this application provides a communication apparatus, where the communication apparatus includes a logic circuit and an interface, the logic circuit is coupled to the interface, the logic circuit is configured to obtain a first bit sequence, and perform LDPC encoding on the first bit sequence based on a check matrix, to obtain a second bit sequence, and the interface is configured to output the second bit sequence.

In a possible implementation, the logic circuit is further configured to perform rate matching on the second bit sequence.

It may be understood that for descriptions of the logic circuit and the interface, refer to the first aspect. Details are not described herein again.

It may be understood that the communication apparatus shown in this embodiment of this application may be referred to as a chip, an encoder, an apparatus having an encoding function, or the like. This is not limited in embodiments of this application.

According to an eighth aspect, an embodiment of this application provides a communication apparatus, where the communication apparatus includes a logic circuit and an interface, the logic circuit is coupled to the interface, and the logic circuit is configured to obtain to-be-decoded information of a second bit sequence, and perform LDPC decoding on the to-be-decoded information of the second bit sequence based on a check matrix, to obtain Ki information bits.

It may be understood that for descriptions of the logic circuit and the interface, refer to the second aspect. Details are not described herein again.

It may be understood that the communication apparatus shown in this embodiment of this application may be referred to as a chip, a decoder, an apparatus having a decoding function, or the like. This is not limited in embodiments of this application.

According to a ninth aspect, an embodiment of this application provides a computer-readable storage medium. The computer-readable storage medium is configured to store a computer program. When the computer program runs on a computer, the method according to any one of the first aspect or the possible implementations of the first aspect is enabled to be performed.

According to a tenth aspect, an embodiment of this application provides a computer-readable storage medium. The computer-readable storage medium is configured to store a computer program. When the computer program runs on a computer, the method according to any one of the second aspect or the possible implementations of the second aspect is enabled to be performed.

According to an eleventh aspect, an embodiment of this application provides a computer program product. The computer program product includes a computer program. When the computer program product is run on a computer, the method according to any one of the first aspect or the possible implementations of the first aspect is enabled to be performed.

According to a twelfth aspect, an embodiment of this application provides a computer program product. The computer program product includes a computer program. When the computer program product runs on a computer, the method according to any one of the second aspect or the possible implementations of the second aspect is enabled to be performed.

According to a thirteenth aspect, an embodiment of this application provides a computer program. When the computer program runs on a computer, the method according to any one of the first aspect or the possible implementations of the first aspect is performed.

According to a fourteenth aspect, an embodiment of this application provides a computer program. When the computer program runs on a computer, the method according to any one of the second aspect or the possible implementations of the second aspect is performed.

According to a fifteenth aspect, an embodiment of this application provides a communication system. The communication system includes a transmit end and a receive end. The transmit end is configured to perform the method according to any one of the first aspect or the possible implementations of the first aspect, and the receive end is configured to perform the method according to any one of the second aspect or the possible implementations of the second aspect.

## BRIEF DESCRIPTION OF DRAWINGS

FIG. 1 is a diagram of an architecture of a communication system according to an embodiment of this application;

FIG. 2a is a diagram of a structure of a BG1 according to an embodiment of this application;

FIG. 2b is a diagram of a structure of a BG2 according to an embodiment of this application;

FIG. 3a is a diagram of a modulation and coding scheme (modulation and coding scheme, MCS) according to an embodiment of this application;

FIG. 3b is a diagram of a maximum code rate supported by a BG1 according to an embodiment of this application;

FIG. 4 is a schematic flowchart of an encoding method and a decoding method according to an embodiment of this application;

FIG. 5a is a diagram of a newly added information column according to an embodiment of this application;

FIG. 5b is a diagram of a newly added information column based on a BG1 according to an embodiment of this application;

FIG. 5c is a diagram of a newly added information column based on a BG2 according to an embodiment of this application;

FIG. 6a is a diagram of a simulation result according to an embodiment of this application;

FIG. 6b is a diagram of a simulation result according to an embodiment of this application;

FIG. 7 is a diagram of a simulation result according to an embodiment of this application;

FIG. 8 is a diagram of a structure of a communication apparatus according to an embodiment of this application;

FIG. 9 is a diagram of a structure of a communication apparatus according to an embodiment of this application; and

FIG. 10 is a diagram of a structure of a communication apparatus according to an embodiment of this application.

## DESCRIPTION OF EMBODIMENTS

To make the objectives, technical solutions, and advantages of this application clearer, this application is further described below with reference to the accompanying drawings.

Terms such as "first" and "second" in the specification, claims, and accompanying drawings of this application are merely used to distinguish between different objects, and are not used to describe a specific order. In addition, terms "include" and "have" and any other variants thereof are intended to cover a non-exclusive inclusion. For example, processes, methods, systems, products, or devices that include a series of steps or units are not limited to listed steps or units, but instead, optionally further include steps or units that are not listed, or optionally further include other steps or units inherent to these processes, methods, products, or devices.

"Embodiments" mentioned herein mean that specific features, structures, or characteristics described in combination with the embodiments may be included in at least one embodiment of this application. The phrase shown in various locations in the specification may not necessarily refer to a same embodiment, and is not an independent or optional embodiment exclusive from another embodiment. It may be understood explicitly and implicitly by a person skilled in the art that the embodiments described herein may be combined with other embodiments.

In this application, "at least one (item)" means one or more, "a plurality of" means two or more, "at least two (items)" means two or three or more, and "and/or" is used to describe an association relationship between associated objects, which indicates that three relationships may exist. For example, "A and/or B" may indicate: only A exists, only B exists, and both A and B exist. A and B may be singular or plural. "A or B" may represent three cases: only A exists, only B exists, and A and B exist when A and B do not conflict. The character "/" generally indicates an "or" relationship between the associated objects. "At least one of the following items (pieces)" or a similar expression means any combination of these items. For example, at least one of a, b, or c may represent: a, b, c, "a and b", "a and c", "b and c", or "a, b, and c".

The technical solutions provided in embodiments of this application may be applied to various communication systems, for example, an Internet of Things (Internet of Things, IoT) system, a narrow band Internet of Things (narrow band Internet of Things, NB-IoT) system, a long term evolution (long term evolution, LTE) system, a 5th generation (5th generation, 5G) communication system, a new radio (new radio, NR) system, and a new communication system that emerges in future communication development.

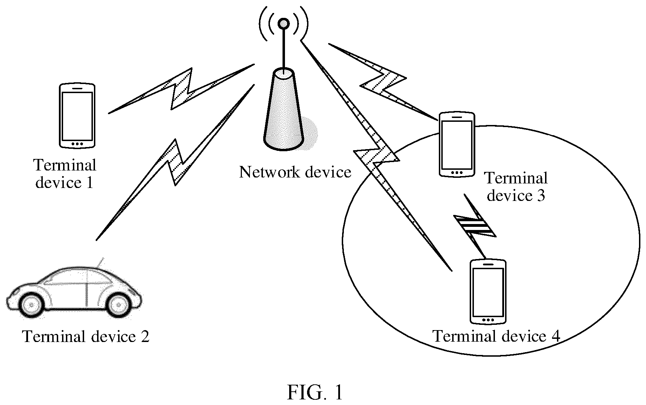

The technical solutions provided in embodiments of this application may also be applied to non-terrestrial network (non-terrestrial network, NTN) communication (which may also be referred to as non-terrestrial network communication), machine type communication (machine type communication, MTC), a long term evolution-machine (long term evolution-machine, LTE-M) technology, a device-to-device (device-to-device, D2D) network, a machine-to-machine (machine-to-machine, M2M) network, an Internet of Things (Internet of Things, IoT) network, an industrial Internet, or another network. The IoT network may include, for example, an Internet of vehicles. Communication modes in the Internet of vehicles system are collectively referred to as vehicle-to-everything (vehicle-to-everything, V2X, where X may represent everything). For example, the V2X may include vehicle-to-vehicle (vehicle-to-vehicle, V2V) communication, vehicle-to-infrastructure (vehicle-to-infrastructure, V2I) communication, vehicle-to-pedestrian (vehicle-to-pedestrian, V2P) communication, or vehicle-to-network (vehicle-to-network, V2N) communication. For example, in FIG. 1 described below, terminal devices may communicate with each other by using the D2D technology, the M2M technology, or the V2X technology.

The technical solutions provided in embodiments of this application may also be applied to a wireless local area network (wireless local area network, WLAN) system, for example, Wi-Fi. For example, methods provided in embodiments of this application are applicable to the Institute of Electrical and Electronics Engineers (institute of electrical and electronics engineers, IEEE) 802.11 series protocols, such as the 802.11a/b/g protocol, the 802.11n protocol, the 802.11ac protocol, the 802.11ax protocol, the 802.11be protocol, and a next generation protocol. Other applicable protocols are not listed one by one herein. For another example, the methods are also applicable to a wireless personal area network (wireless personal area network, WPAN) based on an ultra wideband (ultra wideband, UWB) technology, such as the 802.15.4a protocol, the 802.15.4z protocol, and the 802.15.4ab protocol in the IEEE 802.15 series protocols, or a future generation of UWB WPAN protocol. Other applicable protocols are not listed one by one herein. A person skilled in the art easily understands that various aspects in embodiments of this application may be extended to other networks using various standards or protocols, for example, Bluetooth (Bluetooth), a high performance radio LAN (high performance radio LAN, HIPERLAN) (which is a wireless standard similar to the IEEE 802.11 standard, and is mainly used in Europe), a wide area network (WAN), or another network known or developed in the future. Therefore, regardless of coverage and a wireless access protocol that are used, the technical solutions provided in embodiments of this application are applicable to any suitable wireless network.

In a possible implementation, FIG. 1 is a diagram of an architecture of a communication system according to an embodiment of this application. As shown in FIG. 1, the communication system may include at least one network device and at least one terminal device, for example, a terminal device 1 to a terminal device 4 in FIG. 1. For example, the terminal device 3 and the terminal device 4 shown in FIG. 1 may directly communicate with each other. For example, direct communication between the terminal devices may be implemented by using the D2D technology. For example, the terminal device 1 to the terminal device 4 may separately communicate with the network device. For example, the terminal device 3 and the terminal device 4 may directly communicate with the network device, or may indirectly communicate with the network device, for example, communicate with the network device via another terminal device (not shown in FIG. 1). It should be understood that FIG. 1 shows an example of one network device, four terminal devices, and communication links between the communication devices. Optionally, the communication system may include a plurality of network devices, and another number of terminal devices, for example, more or fewer terminal devices, may be included in coverage of each network device. This is not limited in embodiments of this application. The following describes the terminal device and the network device in detail.

The terminal device is an apparatus having a wireless transceiver function. The terminal device may communicate with an access network device (also referred to as an access device) in a radio access network (radio access network, RAN). The terminal device may also be referred to as user equipment (user equipment, UE), an access terminal, a terminal (terminal), a subscriber unit (subscriber unit), a subscriber station, a mobile station, a remote station, a remote terminal, a mobile device, a user terminal, a user agent, a user apparatus, or the like. In a possible implementation, the terminal device may be deployed on land, including an indoor, outdoor, handheld, or vehicle-mounted device; may be deployed on the water (for example, a ship), or the like. In a possible implementation, the terminal device may be a handheld device having a wireless communication function, a vehicle-mounted device, a wearable device, a sensor, a terminal in an Internet of Things, a terminal in an Internet of vehicles, an unmanned aerial vehicle, a terminal device in any form in a 5G network or a future network, or the like. This is not limited in embodiments of this application. It may be understood that the terminal device described in embodiments of this application may include a vehicle (for example, a car) in the Internet of vehicles, and may further include a vehicle-mounted device, a vehicle-mounted terminal, or the like in the Internet of vehicles. A specific form of the terminal device used in the Internet of vehicles is not limited in embodiments of this application. It may be understood that the terminal devices shown in this embodiment of this application may further communicate with each other by using a technology such as D2D, V2X, or M2M. A communication method between the terminal devices is not limited in embodiments of this application.

The network device may be an apparatus that is deployed in the radio access network and that provides a wireless communication service for the terminal device. The network device may also be referred to as an access network device, an access device, a RAN device, or the like. For example, the network device may be a next generation NodeB (next generation NodeB, gNB), a next generation evolved NodeB (next generation evolved NodeB, ng-eNB), a network device in 6G communication, or the like. The network device may be any device having a wireless transceiver function, and includes, but is not limited to, the base stations shown above (including a base station deployed on a satellite). Alternatively, the network device may be an apparatus having a base station function in 6G. Optionally, the network device may be an access node, a wireless relay node, a wireless backhaul node, or the like in a Wi-Fi system. Optionally, the network device may be a radio controller in a cloud radio access network (cloud radio access network, CRAN) scenario. Optionally, the network device may be a wearable device, a vehicle-mounted device, or the like. Optionally, the network device may be a small cell, a transmission reception point (transmission reception point, TRP) (which may also be referred to as a transmission point), or the like.

It may be understood that the network device may alternatively be a base station, a satellite, or the like in a future evolved public land mobile network (public land mobile network, PLMN). The network device may alternatively be a communication apparatus or the like functioning as a base station in a non-terrestrial communication system, D2D, V2X, or M2M. A specific type of the network device is not limited in embodiments of this application. In systems using different radio access technologies, names of communication apparatuses having functions of network devices may be different, and are not listed in this embodiment of this application. Optionally, in some deployments of the network device, the network device may include a central unit (central unit, CU), a distributed unit (distributed unit, DU), and the like. In some other deployments of the network device, the CU may be further divided into a CU-control plane (control plane, CP), a CU-user plane (user plane, UP), and the like. In some other deployments of the network device, the network device may alternatively be an antenna unit (radio unit, RU), or the like. In still some other deployments of the network device, the network device may alternatively be an open radio access network (open radio access network, ORAN) architecture or the like. A specific deployment manner of the network device is not limited in embodiments of this application. For example, when the network device is of the ORAN architecture, the network device in embodiments of this application may be an access network device in an ORAN, a module in the access network device, or the like. In an ORAN system, the CU may also be referred to as an open (open, O)-CU, the DU may also be referred to as an O-DU, the CU-CP may also be referred to as an O-CU-CP, the CU-UP may also be referred to as an O-CU-UP, and the RU may also be referred to as an O-RU. The deployment manner of the network device listed herein is merely an example. With evolution of standard technologies, the network device may have another deployment form. However, any manner in which a frequency band switching method shown in embodiments of this application can be implemented is within the protection scope of the embodiments of this application.

A network architecture and a service scenario that are described in embodiments of this application are intended to describe the technical solutions in embodiments of this application more clearly, but do not constitute any limitation on the technical solutions provided in embodiments of this application. A person of ordinary skill in the art can know that, as a network architecture evolves and a new service scenario emerges, the technical solutions provided in embodiments of this application are also applicable to similar technical issues.

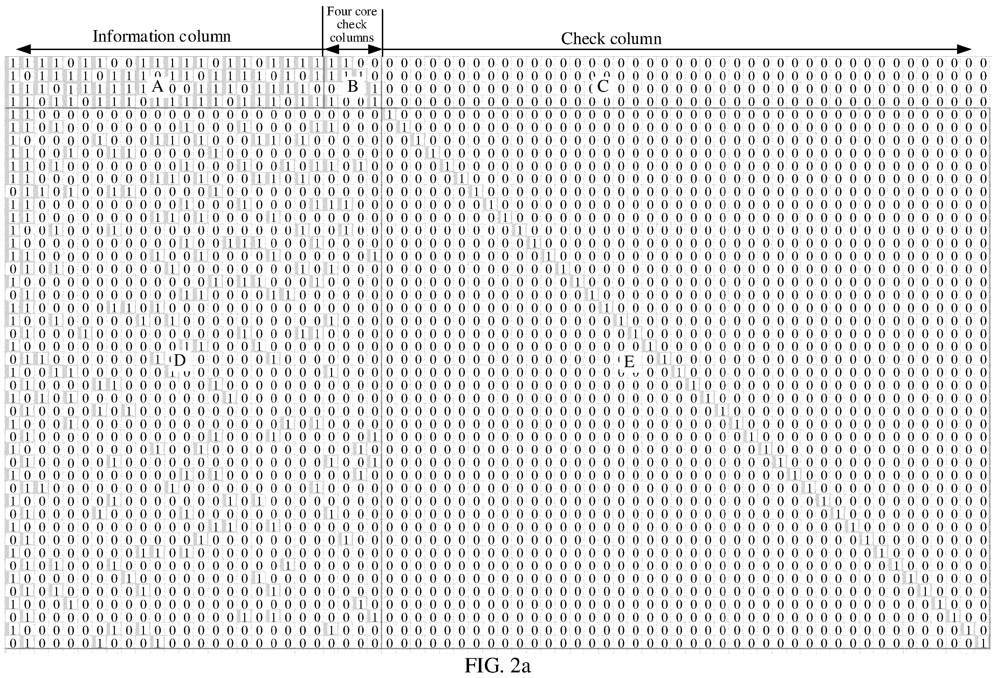

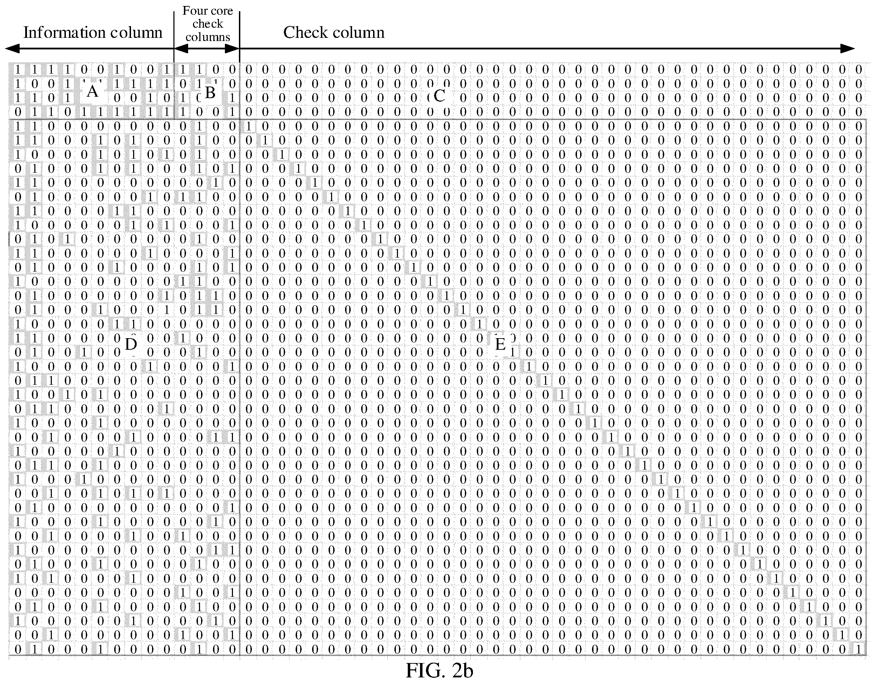

Generally, the LDPC code may have a quasi-cyclic (quasi-cyclic, QC) structure. A shift value (shift value) of each block is set, so that a bad structure such as a short circle can be effectively improved, and a code distance can be increased. For example, an actually used LDPC code is used to extend 1 in a base graph (base graph, BG) (or a base matrix) to a cyclic shift matrix, for example, a value 1 of each node in a BG1 shown in FIG. 2a, and a value 1 of each node in a BG2 shown in FIG. 2b. For a block division status of the BG1, refer to a block A (also referred to as an area A), a block B (also referred to as an area B), a block C (also referred to as an area C), a block D (also referred to as an area D), and a block E (also referred to as a block E) in FIG. 2a. For a block division status of the BG2, refer to a block A, a block B, a block C, a block D, and a block E in FIG. 2b. A BG model of a QC-LDPC code is BG=(X, Y, F), where X corresponds to a variable, Y corresponds to a check equation, and F corresponds to an edge connection relationship between X and Y. An LDPC factor graph (also referred to as an induced subgraph) (for example, a tanner graph) G=(V, C, E) is obtained through QC lifting with a lifting size (also referred to as an extension factor) of $Zc$ performed on the BG model. V is a variable node, C is a check node, E is an edge connection relationship (also referred to as a connection relationship) between the variable node and the check node, and a corresponding quantity of columns of the check matrix is $N=|V|=Zc*|X|$, a quantity of rows of the check matrix is $M=|C|=Zc*|Y|$, and a quantity of non-zero elements of the check matrix is $|E|=Zc*|F|$. The tanner graph may be understood as a graph that represents a connection relationship between a check node and a variable node. As shown in FIG. 2a and FIG. 2b, a connection relationship between one variable node and one check node may be determined by using a value of a node in the base graph. For example, if a value of a node is 1, it represents that there is a connection relationship between a variable node and a check node that correspond to the node. If a value of a node is 0, it represents that there is no connection relationship between a variable node and a check node that correspond to the node.

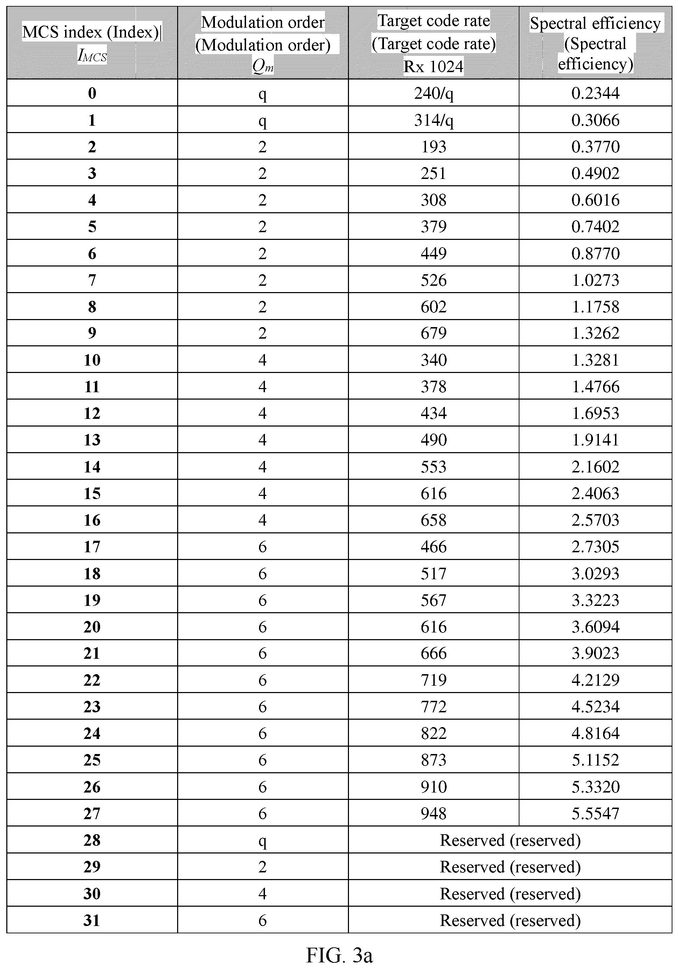

For example, as shown in FIG. 3a, a maximum used code rate specified in a 5G data channel modulation and coding scheme (modulation and coding scheme, MCS) table is 0.926 (for example, 948/1024 in FIG. 3a). When channel quality is good, a high MCS may be actually used in a communication system, and a higher MCS may be used in a future 6G scenario. Generally, a code rate corresponding to a high MCS is a high code rate, because performance at a low code rate and a high modulation order is not as good as performance with a higher code rate and a lower modulation order in a same case. Therefore, a high MCS corresponds to a high code rate.

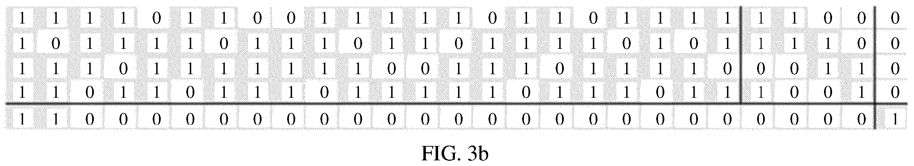

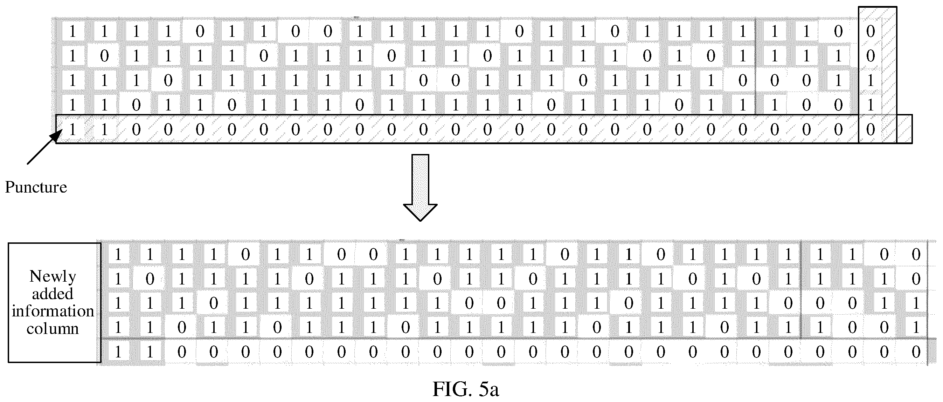

When a check matrix of a 5G NR LDPC code has a high code rate, a BG1 may be used. A core part of the BG1 includes five rows and 27 columns, where there are 22 information columns, and a code rate is 0.88. As shown in FIG. 3b, the first four rows of the BG1 are densely connected (for example, a row weight of the first four rows is 19), and the fifth row is sparse (for example, a row weight of the fifth row is 1). Parity bits of the first four rows are core parity bits, for example, referred to as a core check column, and a parity bit of the fifth row is an extended parity bit, for example, referred to as an extended check column. A column weight of the core check column is greater than 1, and a column weight of the extended check column is equal to 1. Even if four rows and 26 columns (which may also be referred to as a core matrix) that are most dense in the core part are captured, a maximum code rate that can be supported by the BG1 is 0.916. If 0.926 needs to be achieved, corresponding puncturing (puncturing) processing needs to be performed on a parity bit of the last column, to achieve a target code rate. It may be understood that the maximum code rate supported by the BG1 shown herein may be 0.916, and information columns corresponding to the maximum code rate may be four rows and 22 columns of information columns and four rows and four columns of core check columns shown in FIG. 3b (or refer to four rows and 26 columns shown in FIG. 5a). That is, for example, N=26, as described below. Because the BG1 supports a code rate higher than that of a BG2, the BG1 is used as an example in this embodiment of this application, but the BG1 should not be understood as a limitation on this embodiment of this application.

However, the target code rate is achieved in the foregoing manner of puncturing processing, causing a performance loss. If the last column of parity bits is punctured, it is equivalent to a case in which the last row of a check equation is not used. As a result, degree distribution of variable nodes is greatly different from that in a design, and performance is affected.

In view of this, embodiments of this application provide an encoding method, a decoding method, and an apparatus, to increase a code rate by newly adding an information column to an existing base graph. For example, an LDPC code at a high code rate is constructed by using a newly added information column and indication information described below, so that an edge density is improved. When additional complexity is low, there is a performance gain in a case of a high code rate, and there is no performance loss in a case of a low code rate.

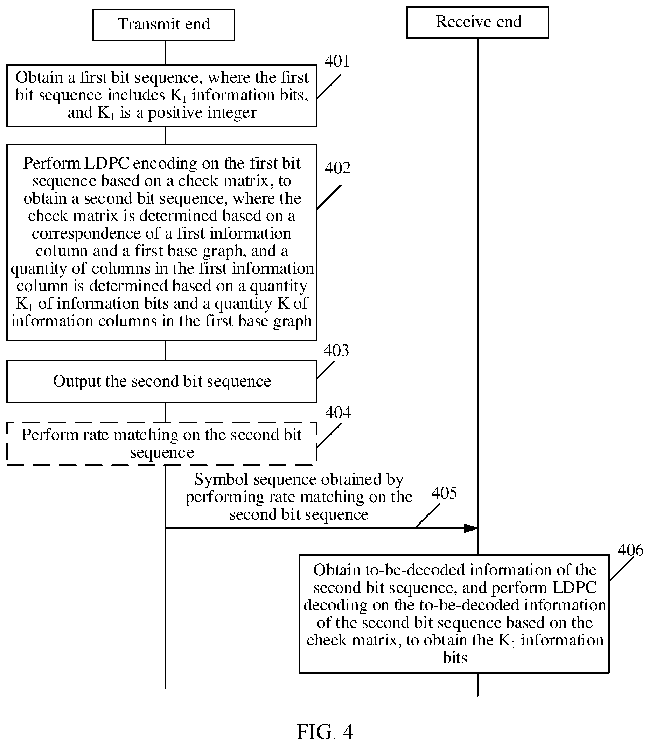

FIG. 4 is a schematic flowchart of an encoding method and a decoding method according to an embodiment of this application. The method may be applied to a transmit end and a receive end. The transmit end may be understood as an end that sends information, and the receive end may be understood as an end that receives information. Alternatively, the transmit end may be understood as an encoding end, and the receive end may be understood as a decoder. For example, the transmit end may be a network device (for example, a base station), and the receive end may be a terminal device; or the transmit end may be a terminal device, and the receive end may be a network device; or the transmit end may be an AP, and the receive end may be a STA; or both the transmit end and the receive end may be terminal devices (or STAs). This is not limited in embodiments of this application. For a communication system to which embodiments of this application are applied, refer to FIG. 1. Details are not described herein again. It may be understood that in embodiments of this application, the method provided in embodiments of this application is described based on two sides: the transmit end and the receive end. However, in an information transmission process of the transmit end and the receive end, there may be another apparatus. For example, a forwarding apparatus is used to forward information between the transmit end and the receive end. Therefore, mutual transfer of information in embodiments of this application may be implemented through a technical means that can be completed by a person skilled in the art, and an apparatus other than the transmit end and the receive end is not limited in embodiments of this application.

As shown in FIG. 4, the method includes the following steps.

401: The transmit end obtains a first bit sequence, where the first bit sequence includes Ki information bits, and Ki is a positive integer.

The Ki information bits may be understood as bits that need to be transmitted and include an information amount. Optionally, the Ki information bits may include cyclic redundancy check (cyclic redundancy check, CRC). Optionally, the Ki information bits may not include the CRC. In this case, the transmit end may add the CRC or not add the CRC in a subsequent process of encoding the Ki information bits.

402: The transmit end performs LDPC encoding on the first bit sequence based on a check matrix, to obtain a second bit sequence. The check matrix is determined based on a correspondence of a first information column and a first base graph, and a quantity of columns in the first information column is determined based on a quantity Ki of information bits and a quantity K of information columns in the first base graph.

In addition to the check matrix, at least one of a target code rate and a target code length may be further used in an encoding/decoding process. The following uses the check matrix and the target code rate as an example. For example, the transmit end may perform LDPC encoding on the first bit sequence based on the check matrix and the target code rate. Correspondingly, the receive end may perform LDPC decoding on to-be-decoded information of the second bit sequence based on the check matrix and the target code rate. The target code rate may be dynamically or statically configured by a network device for a terminal device. For example, the network device may send information including the target code rate to the terminal device by using radio resource control (radio resource control, RRC) signaling. For another example, the network device may send information including the target code rate to the terminal device by using downlink control information (downlink control information, DCI); or the network device may deliver information including the target code rate to the terminal device in a broadcast manner. This is not limited in embodiments of this application.

Optionally, elements in a base matrix (also referred to as a base matrix) may include 0 and 1, and the check matrix (which may also be referred to as an encoding matrix, a decoding matrix, or the like) is obtained through lifting based on a lifting size, a shift value, and the base matrix. For example, elements in the check matrix may include 0 and 1. Optionally, to save storage space, the check matrix may be in the following form: "-1" in the check matrix may represent an all-zero matrix of Zc*Zc, "0" in the check matrix may represent a unit matrix of Zc*Zc, a non-zero element in the check matrix may represent a circulant permutation matrix (circulant permutation matrix, CPM) of Zc*Zc, and Zc represents a lifting size used when the check matrix is obtained by lifting a base graph (or a base matrix). The base graph described herein may be determined based on the correspondence of the first information column and the first base graph.

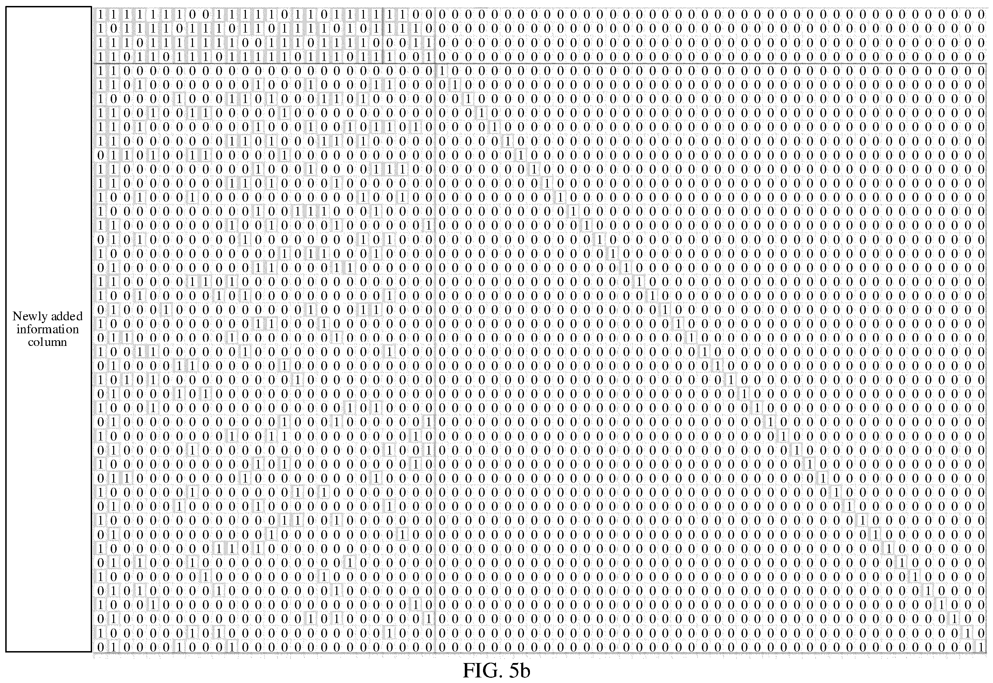

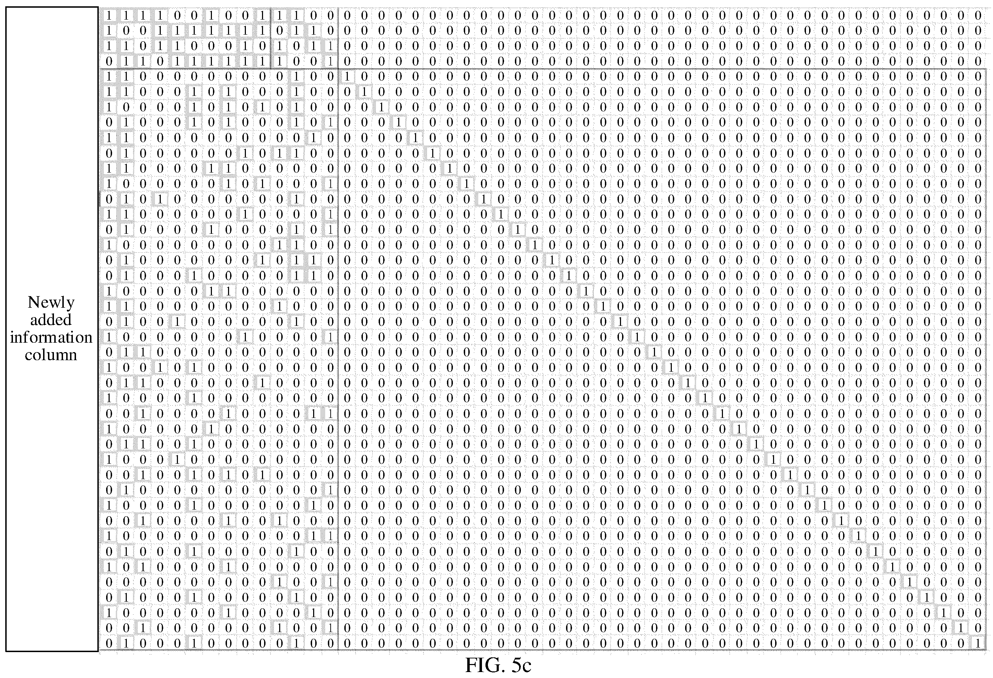

The first information column may be understood as an information column newly added based on the first base graph. For example, the transmit end may add an additional information column to a base graph that has been stored in a current standard, or this is described as that the transmit end may add an additional information column to a base matrix that has been stored in the current standard. The first base graph may be an existing base graph. For example, the first base graph may include a BG1, a BG2, or another base graph. Examples are not listed one by one in embodiments of this application. FIG. 5b is a diagram of a newly added information column based on the BG1 according to an embodiment of this application. FIG. 5c is a diagram of a newly added information column based on the BG2 according to an embodiment of this application. Specific content of the newly added information columns in FIG. 5b and FIG. 5c is not limited in embodiments of this application.

For conditions that the first information column and the quantity of columns in the first information column satisfy, refer to the following.

In a high bit rate solution based on the newly added information column provided in embodiments of this application, if a total quantity of information columns (for example, including an initial information column of an LDPC code check matrix) in the first base graph is K, a quantity of punctured information columns is P, and a quantity of used check columns is C, a corresponding code rate is $\frac{K}{K-P+C}$. If a quantity of non-punctured information columns added to the first base graph is $K_e$, the code rate changes to $\frac{K+Ke}{K+Ke-P+C}$. Because $\frac{K+Ke}{K+Ke-P+C} > \frac{K}{K-P+C}$, the code rate can be effectively increased by newly adding an information column. An information column is added to adapt to a high code rate matrix, so that a better edge density can be obtained in comparison with a manner of directly performing shortening and/or puncturing (for example, a better degree score of a variable node (namely, a variable node in the first base graph) is obtained in comparison with a manner of performing rate matching on a punctured parity bit), and performance is improved. It can be learned from the foregoing analysis that the code rate can be effectively increased by newly adding an information column to the first base graph. It may be understood that the foregoing code rate formula may be understood as a case in which a complete CPM matrix is considered, and shortening and the like are not considered. Therefore, the foregoing code rate is merely an example, and should not be understood as a limitation on embodiments of this application.

**The first information column in embodiments of this application may satisfy at least one of the following conditions:**

Condition 1: The correspondence of the first information column includes a relationship between a column index in the first information column, a row index in the first information column, and a shift value.

The row index in the first information column may be understood as a row index of a row corresponding to the first information column. For example, the transmit end may learn of a connection relationship between a variable node and a check node in the newly added information column based on the column index in the first information column, the row index in the first information column, and the shift value corresponding to the row index and the column index. Therefore, the transmit end may determine the check matrix based on the correspondence of the first information column and the first base graph. For example, the condition 1 may alternatively be described as follows: The correspondence of the first information column includes at least one of the following: a connection relationship (also referred to as an edge connection relationship) with the variable node as an index, a connection relationship with the check node as an index, and a shift value corresponding to the variable node and the check node. Alternatively, the correspondence of the first information column includes at least one of the following: a mapping relationship with a column in the first information column as an index, a mapping relationship with a row in the first information column as an index, and a corresponding shift value.

In an example, the correspondence of the first information column may include a connection relationship with the variable node as the index and a corresponding shift value. In other words, the transmit end may store the first base graph, a check connection relationship with the newly added information column as an index, and a corresponding shift value. For example, the check connection relationship with the newly added information column as the index may be understood as a connection relationship between a basic index and a row index corresponding to the basic index, where each column in the first information column is used as the basic index (also referred to as a case in which the variable node in the first information column is used as the basic index). For example, a column in the first information column is used as the basic index, the column may correspond to $i_{LS}+1$ columns, the first column in the $i_{LS}+1$ columns may sequentially correspond to check nodes (or row indexes) associated with the column in ascending order, and the second column to an $(i_{LS}+1)^{th}$ column in the $i_{LS}+1$ columns correspond to shift values of a lifting size list.

For example, Table 1 is an example table in which columns in the first information column are used as basic indexes. Table 1 is shown by using an example in which a column index j is 0 (for example, the first column from left to right in the newly added information column) in the first information column. A row index listed in Table 1 represents that there is a connection relationship between the row index and the column index 0, and a row index that is not listed in Table 1 represents that there is no connection relationship (or no edge connection relationship) between the row index and the column index 0. For example, row indexes i=0, i=2, and i=3 listed in Table 1 represent that there is a connection relationship between a variable node corresponding to j=0 and a check node corresponding to i=0 (or a value of a node corresponding to j=0 and i=0 is 1), there is a connection relationship between the variable node corresponding to j=0 and a check node corresponding to i=2 (or a value of a node corresponding to j=0 and i=2 is 1), there is a connection relationship between the variable node corresponding to j=0 and a check node corresponding to i=3 (or a value of a node corresponding to j=0 and i=3 is 1), and there is no connection relationship between the variable node corresponding to j=0 and a check node corresponding to i=1 (or a value of a node corresponding to j=0 and i=1 is 0). It may be understood that values "0" and "1" shown herein are relative. In this embodiment of this application, the following values and meanings are used as examples: A value 1 of a node in a base graph corresponding to a check matrix represents that there is a connection relationship between a variable node and a check node that correspond to the node, and a value 0 of a node represents that there is no connection relationship between a variable node and a check node that correspond to the node.

Table 1

| Column index j | Row index i | Shift value | | | | | | | |
|---|---|---|---|---|---|---|---|---|---|
| | | 0 | 1 | 2 | 3 | 4 | 5 | 6 | 7 |
| 0 | 0 | x11 | x12 | x13 | x14 | x15 | x16 | x17 | x18 |
| | 2 | x21 | x22 | x23 | x24 | x25 | x26 | x27 | x28 |
| | 3 | x31 | x32 | x33 | x34 | x35 | x36 | x37 | x38 |
| | ... | ... | | | | | | | |
| | ... | ... | | | | | | | |
| | ... | ... | | | | | | | |

It may be understood that Table 1 merely shows an example of a relationship between corresponding row indexes when j=0. In a specific implementation, there may be a plurality of columns in the first information column. In this case, the transmit end further needs to store a corresponding row index and a corresponding shift value when j=1 is used as the basic index, a corresponding row index and a corresponding shift value when j=2 is used as the basic index, and the like. Examples are not listed one by one herein. x11 to x18, x21 to x28, and x31 to x38 in Table 1 respectively represent shift values in a case of corresponding lifting sizes. Specific values are not listed one by one in this embodiment of this application.

In another example, the correspondence of the first information column may include a connection relationship with the check node as the index and a corresponding shift value. In other words, the transmit end may store the first base graph, a connection relationship of the newly added information column with the check node as an index, and a corresponding shift value. For example, the connection relationship of the newly added information column with the check node as the index may be understood as a connection relationship between a basic index and a column index corresponding to the basic index, where a row corresponding to the first information column is used as the basic index. For example, a row in the first information column is used as the basic index, the row may correspond to $i_{LS}$+1 columns, the first column in the $i_{LS}$+1 columns may sequentially correspond to variable nodes (or row indexes) associated with the row in ascending order, and the second column to an ($i_{LS}$+1$^{th}$ column in the $i_{LS}$+1 columns correspond to shift values of a lifting size list.

For example, Table 2 is an example table in which rows corresponding to the first information column are used as basic indexes. Table 2 is shown by using an example in which a row index i=0 (for example, the first row from top to bottom in the newly added information column) in the first information column. A column index listed in Table 2 represents that there is a connection relationship between the column index and the row index 0, and a column index not listed in Table 2 represents that there is no connection relationship between the column index and the row index 0. For example, column indexes j=1, j=2, and j=4 listed in Table 2 represent that there is no connection relationship between a check node corresponding to i=1 and a variable node corresponding to j=0 (or a value of a node corresponding to i=1 and j=0 is 0), there is a connection relationship between the check node corresponding to i=1 and a variable node corresponding to j=1 (or a value of a node corresponding to i=1 and j=1 is 1), there is a connection relationship between the check node corresponding to i=1 and a variable node corresponding to j=2 (or a value of a node corresponding to i=1 and j=2 is 1), there is no connection relationship between the check node corresponding to i=1 and a variable node corresponding to j=3 (or a value of a node corresponding to i=1 and j=3 is 0), and there is a connection relationship between the check node corresponding to i=1 and a variable node corresponding to j=4 (or a value of a node corresponding to i=1 and j=4 is 1).

Table 2

| Row index i | Column index j | Shift value | | | | | | | |
|---|---|---|---|---|---|---|---|---|---|
| | | 0 | 1 | 2 | 3 | 4 | 5 | 6 | 7 |
| 0 | 1 | y11 | y12 | y13 | y14 | y15 | y16 | y17 | y18 |
| | 2 | y21 | y22 | y23 | y24 | y25 | y26 | y27 | y28 |
| | 4 | y31 | y32 | y33 | y34 | y35 | y36 | y37 | y38 |
| | ... | ... | | | | | | | |
| | ... | ... | | | | | | | |
| | ... | ... | | | | | | | |

It may be understood that Table 2 merely shows an example of a relationship between corresponding row indexes when i=0. In a specific implementation, there may be a plurality of rows in the first information column. In this case, the transmit end further needs to store a corresponding column index and a corresponding shift value when i=1 is used as the basic index, a corresponding row index and a corresponding shift value when i=2 is used as the basic index, and the like. Examples are not listed one by one herein. y11 to y18, y21 to y28, and y31 to y38 in Table 2 respectively represent shift values in a case of corresponding lifting sizes. Specific values are not listed one by one in this embodiment of this application.

It may be understood that, a lifting size supported by the newly added information column shown in Table 1 and Table 2 is the same as a lifting size supported by the first base graph, and the shift value corresponds to the lifting size. It may be understood that the foregoing manner of the row index and the column index in the first information column is merely an example. For example, the row index and the column index may alternatively be distinguished by using letters, for example, an index A and an index B.

It should be noted that the foregoing content that needs to be stored by the transmit end is also applicable to the receive end. In other words, two communication parties may store the correspondence of the first information column and the first base graph. The two communication parties add storage content, namely, the correspondence of the first information column. In comparison with a first base graph stored by the two communication parties in the current standard, a change is slight. For example, based on the currently stored first base graph (or a base matrix corresponding to the first base graph), the two communication parties additionally add storage content shown in Table 1 or Table 2 (which is only an example).

In still another example, the two communication parties may update a currently stored first base graph (or a base matrix corresponding to the first base graph). For example, the two communication parties may add a new edge connection relationship and a shift value to storage content corresponding to the first base graph, and indicate that the added content is a newly added information column. For example, the two communication parties may add, based on a currently stored table corresponding to the first base graph, a correspondence between a row index and a column index that correspond to the first information column, and a shift value. For example, the two communication parties may determine a new base graph, for example, referred to as a second base graph, based on the correspondence of the first information column and the first base graph. Therefore, the two communication parties may store the second base graph, or store a base matrix corresponding to the second base graph. Optionally, a part that is newly added to the second base graph in comparison with the first base graph may be indicated and described. For example, a manner of indicating whether an information column in the second base graph is a newly added information column may be as follows: Each connection relationship (or each node, or a node corresponding to one row index and one column index) in the second base graph may correspond to one sequence. If a value of the sequence is 0, it may indicate that a connection relationship corresponding to the sequence is a newly added connection relationship. If a value of the sequence is 1, it may indicate that a connection relationship corresponding to the sequence is an existing connection relationship in the first base graph.

It may be understood that a storage manner of the connection relationship of the newly added information column described in this embodiment of this application may be consistent with a storage manner of the connection relationship of the first base graph. Both the newly added information column and the first base graph may be based on a QC structure, and an association between the newly added information column and the check equation of the first base graph may be determined by using the first base graph and the shift value.

Condition 2: In the first information column, a value of each node in the first base graph is not changed.

Generally, the value of each node in the first base graph represents a connection relationship between a check node and a variable node that correspond to the node. In this embodiment of this application, the addition of the first information column in the check matrix does not affect a connection relationship between the check node and the variable node in the first base graph. Therefore, the newly added information column does not affect the value of each node in the first base graph, and is compatible with existing LDPC encoding. A check equation of the newly added information column may relate to the check node and the variable node of the first base graph. In other words, there is no new check equation associated only with the newly added information column.

Condition 3: A difference between an edge density of connected edges of the first information column and an edge density of the first base graph is less than or equal to a first edge density threshold.

It may be understood that the edge density of the connected edges of the first information column may be understood as an edge density of a factor graph about a part of the columns in the factor graph (for example, a tanner graph) of the first information column. The edge density may satisfy the following relationship: Edge density=E/(M*N), where M is a quantity of rows in the first base graph, N is a quantity of columns in the first base graph, and E is a quantity of connected edges. For example, the edge density of the first base graph may be determined based on the quantity of rows in the first base graph, the quantity of columns in the first base graph, the quantity of connected edges, and the foregoing relationship. For another example, the edge density of the first information column may be determined based on the quantity of rows in the first information column, the quantity of columns in the first information column, the quantity of connected edges, and the foregoing relationship. The edge density of the newly added information column is close to the edge density of the first base graph (for example, a difference is less than or equal to the first edge density threshold), so that a high code rate can be dense (for example, a row weight or a quantity of edges is dense and a density is high), a low code rate can be sparse, and the edge density tends to decrease with a decrease in the code rate, to ensure a decoding threshold and optimize the decoding threshold (for example, reduce the decoding threshold).

Optionally, the foregoing descriptions of the relationship between the edge densities may alternatively be replaced with the following: A row weight of a first part of the first information column is greater than a row weight of a second part of the first information column, and the first part and the second part do not overlap. For example, the first part may be a row of the first information column that corresponds to a row of a first block in the first base graph. The first block may be the block A, the block B, or the block C shown in FIG. 2a or FIG. 2b. The second part may be a row of the first information column that corresponds to a row of a second block in the first base graph. The second block may be the block D or the block E shown in FIG. 2a or FIG. 2b. It may be understood that, when a block division status of the first base graph is used as an example, there may be some row weights that are not greater than the row weight of the second part in the first part of the first information column. For example, there may be a row weight of one or two rows (which are only an example) that is less than the row weight of the second part in the first part. It may be understood that the foregoing manner of distinguishing between the first part and the second part is merely an example. In a specific implementation, there may be another manner of distinguishing. This is not limited in embodiments of this application.

Optionally, the difference between the edge density of the connected edges of the first information column and the edge density of the first base graph may be greater than or equal to a second edge density threshold. In other words, the difference between the edge density of the connected edges of the first information column and the edge density of the first base graph may be large. For example, the first part of the first information column is sparse, the second part of the first information column is dense, and an overall density is large. A core part is sparse, so that a decoding threshold in a case of a low bit rate is better, and is applicable to a medium bit rate and a low bit rate, and has better universality. Optionally, the foregoing descriptions of the relationship between the edge densities may alternatively be replaced with the following: The row weight of the first part of the first information column is not greater than the row weight of the second part of the first information column, and the first part and the second part do not overlap. For descriptions of the first part and the second part, refer to the foregoing descriptions. Specific values of the first edge density threshold and the second edge density threshold are not limited in embodiments of this application, and the first edge density threshold may be less than or equal to the second edge density threshold.

Condition 4: The first information column includes a punctured column.

The information column newly added based on the first base graph may include the punctured column. For example, if the first information column includes the punctured column, a higher bit rate can be more easily achieved. For example, the $K_e$ added columns include one information column, and the code rate may be $(K+Ke)/(K+Ke-1-P+C)$ $>(K+Ke)/(K+Ke-P+C)$. For descriptions of the parameters, refer to the foregoing descriptions.

Optionally, the first information column may not include the punctured column. For example, the first base graph may include a punctured column. In this case, the first information column may include a punctured column, or may not include a punctured column. For another example, the first base graph does not include a punctured column, and the first information column may include a punctured column.

In a specific implementation, Condition 1 to Condition 4 may be combined with each other. For example, a part of the newly added information column may correspond to the punctured column, and the other part of the newly added information column corresponds to a non-punctured column. Examples are not listed one by one herein. For example, the newly added information column (including a value of each node in the information column, a total quantity of columns, and the like) may be defined in a standard, or may be negotiated by the two communication parties. For example, the transmit end sends, to the receive end, information indicating the newly added information column, and the receive end feeds back acknowledgment information based on the information. A negotiation process is not limited in embodiments of this application.

Condition 5: The quantity of columns in the first information column is determined based on the quantity Ki of information bits, the total quantity K of information columns in the first base graph, and the target code rate.

For example, when the target code rate is greater than the maximum code rate $R_0$ supported by the first base graph, the quantity of columns in the first information column is related to $K_1$, K, and the target code rate, for example, as described in a rate matching manner 1 and a rate matching manner 2 below. When the target code rate is less than or equal to $R_0$, the quantity of columns in the first information column may be 0. In other words, if a code rate of the first bit sequence is less than or equal to $R_0$, an additional information column (for example, the first information column) may not be added based on the first base graph. If the code rate of the first bit sequence is greater than $R_0$, it indicates that the code rate of the first bit sequence exceeds a range that can be supported by the first base graph (where the supported range described herein may be understood as that an upper bound of the supported code rate is a code rate of the core matrix). Therefore, an additional information column (for example, the first information column) may be added based on the first base graph. Optionally, in addition to adding the additional information column to the first base graph, the edge density of the first base graph may be further adjusted based on indication information. The following describes the indication information.

For example, Condition 5 may also be described as follows: The quantity of columns in the first information column is determined based on the quantity Ki of information bits, the quantity K of information columns in the first base graph, the quantity P of punctured columns in the first base graph, and a target code length $N_1$. For example, the target code rate=$K_1/N_1$, and a code rate that can be supported by the first base graph may be determined based on K and P. Therefore, the quantity of columns in the first information column may be determined based on $K_1$, K, P, and Ni (with reference to the foregoing descriptions).

For example, a maximum quantity $K_{max}$ of columns in the newly added information column and a value of each node corresponding to the maximum quantity of columns are defined in the standard, and the transmit end determines the quantity $K_e$ of columns in the first information column based on at least one of a rate matching manner and a status of a resource used for sending information (for example, a resource allocation status of the first bit sequence). For example, based on different scenarios, a quantity of punctured columns in the newly added information column may be 0 or 1. For example, in a data control channel fusion scenario, when channel quality is stable, the first information column includes a punctured column. For another example, in a scenario in which storage is performed based on encoding, the first information column may not include a punctured column. Optionally, the transmit end may send information including $K_e$ to the receive end. It may be understood that for specific descriptions of $K_e$, refer to the following descriptions about rate matching.

It may be understood that a name of the first information column described in this embodiment of this application is merely an example. During actual application, there may be another naming manner for a newly added information column. This is not limited in embodiments of this application.

Generally, a design principle of a matrix (for example, the BG1) of the LDPC code is to ensure an optimal code rate of 0.88. In a case of a higher MCS, an edge density of a base graph may be not an optimal density, and if rate matching is performed at a high code rate in a puncturing manner, a performance loss is further caused. Therefore, in embodiments of this application, the edge density in the first base graph may be adjusted based on the indication information.

**The indication information in embodiments of this application may be as follows:**

In a possible implementation, that the check matrix is determined based on the correspondence of the first information column and the first base graph includes: A first check matrix is determined based on the correspondence of the first information column, the first base graph, and the indication information, where the indication information indicates to change a value of at least one node in the first base graph. For example, as described above, if a value of a node in the first base graph is 1, it may indicate that there is a connection relationship between a check node and a variable node corresponding to the node. If a value of a node in the first base graph is 0, it may indicate that there is no connection relationship between a check node and a variable node that correspond to the node. Therefore, that the indication information indicates to change the value of the at least one node in the first base graph may include: The indication information indicates to change the value of the at least one node in the first base graph from 1 to 0.

In this embodiment of this application, that the indication information indicates to change the value of the at least one node in the first base graph may be understood as follows: The indication information indicates to delete at least one connected edge in the first base graph, and the connected edge may be understood as a connected edge between a check node and a variable node; or the indication information indicates to delete at least one connection relationship between a check node and a variable node in the first base graph. Based on the indication information, the transmit end may update a value of a node indicated by the indication information in the first base graph, and determine the check matrix based on the correspondence of the first information column and an updated first base graph. The connection relationship that is between the check node and the variable node in the updated first base graph and that is determined based on the indication information may be understood as a subset of the connection relationship between the check node and the variable node in the first base graph. For example, in a specific code rate interval (for example, a high code rate interval, for example, greater than 0.9, or greater than 0.92), encoding is not performed by using all connected edges in the first base graph, but is performed by using the first base graph updated based on the indication information. For example, each node in the first base graph corresponds to one shift value. Therefore, when a value of a node is changed from 1 to 0, a shift value corresponding to the node is not used.

For example, the indication information may be defined in the standard, so that the indication information is stored in the two communication parties. For example, the indication information may alternatively be sent by the network device to the terminal device.

The check matrix is determined based on the correspondence of the first information column, the first base graph, and the indication information. There may be the following two specific manners:

In an example, a check matrix list corresponding to the LDPC factor graph $G=(V, C, E)$ stores all edge connection relationships $E$, and additional indication information such as an indication sequence $\theta$ is added. In this case, a length of the indication sequence is $|\theta|=|E|$. For example, $\theta(i, j)$ may be an indication value of a node corresponding to a check node i (also referred to as a row index i) and a variable node j (also referred to as a column index j), and $\theta(i, j) \in \{0, 1\}$. When $\theta(i, j) \in \{0\}$, it may indicate to delete a connection relationship between the check node i and the variable node j, or change a value of a node corresponding to the check node i and the variable node j, for example, from 1 to 0. For another example, $\theta(m)$ may be an indication value corresponding to an $m^{th}$ edge, $\theta(m) \in \{0, 1\}$, and when $\theta(m) \in \{0\}$, it may indicate to delete the $m^{th}$ edge. For example, there is a correspondence between the $m^{th}$ edge and a row index and a column index in the first base graph. Generally, two communication parties store a matrix corresponding to the first base graph. For example, for a storage manner, refer to Table 3. Therefore, for example, the first edge may be understood as a connected edge corresponding to a row index 0 and a column index 0, the second edge may be understood as a connected edge corresponding to the row index 0 and a column index 1, the third edge may be understood as a connected edge corresponding to the row index 0 and a column index 2, ..., a connected edge corresponding to a row index x and a column index y, and so on (which is sequentially arranged in a row sequence). Alternatively, the first edge may be understood as a connected edge corresponding to a column index 0 and a row index 0, the second edge may be understood as a connected edge corresponding to the column index 0 and a row index 1, the third edge may be understood as a connected edge corresponding to the column index 0 and a row index 2, ..., a connected edge corresponding to a column index y and a row index x, and so on (which is sequentially arranged in a column sequence). In other words, $\theta(i, j)$ described above may be understood as a two-dimensional manner to indicate whether to change a value of a node, and $\theta(m)$ may be understood as a one-dimensional manner to indicate whether to change a value of a node. There is a correspondence between a value of m and i and j. It may be understood that, in this embodiment of this application, a value of i may be determined based on a row index of a check node, and a value of j may be determined based on a column index of a variable node. For example, if the row index of the check node ranges from 0 to 22, the value of i may range from 0 to 22. Alternatively, if a minimum value of the row index of the check node is 0, i may be a nonnegative integer. For the value of m, refer to the descriptions of i and j. Details are not described herein again. x may be understood as a maximum value of the row index, and y may be understood as a maximum value of the column index. The indication information in this embodiment of this application may indicate a subset of an unused BG, or this may be understood as that the indication information indicates an unused connected edge.

When the code rate is in a target interval, the transmit end may determine, based on $\theta(i, j)$ or $\theta(m)$, whether to use an edge in the first base graph for encoding. That the edge is not used includes: Encoding at this position in the encoding matrix is skipped or the first base graph is updated, a corresponding check matrix does not include this position or a corresponding shift value, and the receive end does not perform decoding at this position.

For example, the indication information may be determined based on a code rate. For example, there may be a correspondence between the code rate and the indication information. For example, when the code rate is from 0.9 to 0.92, the indication information may indicate to change values of nodes corresponding to the row index i=3 and the column index j=2 in the first base graph. For another example, when the code rate is from 0.92 to 0.93, the indication information may indicate to change values of nodes corresponding to a row index i=5 and a column index j=8 in the first base graph. For another example, when the code rate is from 0.93 to 0.935, the indication information may indicate to change values of nodes corresponding to a row index i=4 and the column index j=2 in the first base graph and values of nodes corresponding to a row index i=9 and a column index j=5 in the first base graph. It may be understood that the relationship between the code rate and the indication information described herein is merely an example, and should not be understood as a limitation on this embodiment of this application. In conclusion, the two communication parties may store a code rate set. If the code rate set includes a plurality of code rates, each code rate in the code rate set may correspond to one piece of indication information. For another example, the code rate set may include a plurality of code rate ranges, and each code rate range may correspond to one piece of indication information.

In another example, the two communication parties may store an edge connection relationship and a corresponding shift value that are used by a main code rate. For example, the edge connection relationship and the corresponding shift value that correspond to the main code rate are stored in an LDPC check matrix list. The main code rate may be a code rate set. The two communication parties may further additionally store some edge connection relationships and corresponding shift values, and the additionally stored content may be used for matching a code rate outside the code rate set. In other words, if the code rate is within a range of the code rate set, the two communication parties may use an edge connection relationship corresponding to the main code rate and a corresponding shift value, for example, construct the encoding matrix and the check matrix by using a list storing the check matrix, an additional edge connection relationship, and a corresponding shift value. If the code rate is not within the range of the code rate set, the two communication parties may update the check matrix based on the additionally stored edge connection relationship and the shift value, for example, construct the encoding matrix and the check matrix by using the edge connection relationship and the shift value that correspond to the list storing the check matrix. The indication information in this embodiment of this application may indicate a subset of a used BG, or may indicate a used connected edge. For ease of description, the following uses an example in which the indication information indicates an unused connected edge to describe a condition satisfied by the indication information.

It may be understood that the foregoing correspondence between the code rate and the indication information is merely an example. For example, there may be a correspondence between the indication information and a code length, or there may be a correspondence between the indication information and a quantity of parity bit columns (a quantity of rows of a check matrix). Certainly, there may be a correspondence between the indication information and an application scenario. In other words, the indication information may have a correspondence with at least one of the following: the code rate, the code length, the quantity of parity bit columns (or a quantity of parity bit rows), and the application scenario. For example, the BG1 supports a short code length, and a density of the base graph may be reduced by deleting some connected edges by using the indication information, to reduce a quantity of short circles, to achieve better decoding performance. For another example, in a high-throughput scenario, some connected edges may be deleted by using the indication information, to reduce a quantity of QC blocks, reduce a decoding delay, and reduce decoding complexity.

In addition to using the code rate as a criterion for using the indication information, the indication information may alternatively be determined based on another indicator such as the code length. The indication information may include a plurality of pieces of information, and each piece of information may separately indicate a connected edge in a BG in a scenario with a different code rate or code length, or another application requirement.

It may be understood that the indication information described in this embodiment of this application may also be referred to as an indication sequence, a position indication column, a newly added indication column, or the like. A specific name of the indication information is not limited in embodiments of this application.

With reference to the foregoing descriptions of the indication information, the indication information may satisfy at least one of the following conditions:

Condition 6: There is a correspondence between the indication information and the code rate.

For descriptions of Condition 6, refer to the foregoing descriptions. Details are not described herein again.

Condition 7: The connected edge indicated by the indication information may be based on the QC structure. For example, the indication information may indicate to change a value of at least one node in the first base graph. For example, the indication information may indicate not to use a connected edge in the first base graph. For example, a unit of the indication information may be a node in the first base graph, or a QC structure in the check matrix. The node in the first base graph is used as a unit, or the QC structure in the check matrix is used as a unit, so that an implementation is simple.

Condition 8: In comparison with the first base graph, a new edge connection relationship is not added to the second base graph based on the first base graph (in other words, no new edge connection relationship appears in a part in the second base graph that corresponds to the first base graph). The second base graph is determined based on the correspondence of the first information column, the indication information, and the first base graph. In other words, the second base graph may be understood as a base graph obtained by updating the first base graph based on the correspondence of the first information column and the indication information.

In other words, when the value of the at least one node in the first base graph is changed based on the indication information, a value of one or more nodes in the first base graph is not changed from 0 to 1, and correspondingly, no new shift value appears. For example, the two communication parties may store an initial edge connection relationship (for example, all edge connection relationships of the tanner graph) of the first base graph, and before encoding the first bit sequence, may determine the check matrix based on the correspondence of the first information column, the indication information, and the first base graph.

Condition 9: The indication information is determined based on a reliability order. For example, the reliability order may be determined based on a decoding threshold. Generally, an original base graph (for example, the BG1 or the BG2) may be understood as an LDPC code with a good threshold optimized by using a protograph-based extrinsic information transfer (protograph-based extrinsic information transfer, PEXIT) method. In this embodiment of this application, after a new information column is added to the original base graph (namely, the first base graph described above), if all the connected edges are kept in the first base graph, a non-optimal threshold may be caused. Therefore, deleting an edge by using the indication information corresponds to a new threshold. In this way, a reliability order corresponding to the connected edges can be obtained after sequential sorting. Optionally, in a process of determining the reliability order by deleting the edge, the reliability order of the information columns may alternatively be determined based on at least one of the column weights of the information columns in the first base graph and the punctured columns, and then the connected edge is deleted from the information columns determined based on the reliability order, to ensure that the decoding threshold is better. For example, a larger column weight of an information column in the first base graph indicates higher reliability corresponding to the information column, that is, the column weight may be positively correlated with the reliability. Generally, reliability corresponding to the punctured column is low. However, because the column weight corresponding to the punctured column is high, reliability corresponding to the punctured column may be improved in this embodiment of this application. After the reliability order of the information columns is determined, a value of a node in an information column in a specific reliability order may be changed (or a connected edge in the information column in the specific reliability order is deleted) based on the reliability order of the information columns. It may be understood that the foregoing steps are merely examples. In a specific implementation, the two communication parties may not need to perform the foregoing steps, but are based on a final result of the foregoing steps. For example, the two communication parties may store a correspondence between the reliability order, the decoding threshold, and the indication information. For another example, the two communication parties may store a correspondence between the reliability order of the information columns and the indication information. For another example, the two communication parties may store a correspondence between the reliability order of the information columns, the decoding threshold, and the indication information. Examples are not listed one by one in embodiments of this application.

For example, the node indicated by the indication information may be located in at least one of an area A and an area D. For example, the node indicated by the indication information may be located in at least one of an area B, the area A, and the area B. For example, when the indication information indicates to delete a connected edge in the area B, it may be further ensured that a full rank of a binary field is still satisfied after the connected edge in the area B is deleted. For example, an area C is an empty set, and therefore, there is no case of deleting a connected edge. To avoid damaging a check relationship, there is no case of deleting a connected edge in an area E. For example, the indication information may indicate to delete a connected edge from an induced subgraph B(C, V) of a variable node or an induced subgraph B(C, V) of a check node in an area in the first base graph. For example, for the BG1 or the BG2, the area may be at least one of a block A area, a block B area, or the area D shown in FIG. 2a or FIG. 2b.

Condition 10: The node indicated by the indication information may be related to a variable node. For example, the indication information may indicate to delete a variable node in a variable node set, and not to delete a variable node that does not belong to the variable node set. For example, if there are 22 variable nodes, some 1s in column 1 to column 5 may be deleted based on the indication information.

Condition 11: The indication information does not include a value of a node whose column weight is 1 in the first base graph.

In other words, the indication information does not include a value corresponding to a variable node in an extended part whose degree is 1 in the first base graph. Using FIG. 2a and FIG. 2b as an example, the indication information does not include a value of a node in a block E area.

403: The transmit end outputs the second bit sequence.

It may be understood that, after the second bit sequence is output, a symbol sequence may be further obtained through operations such as rate matching, modulation, and frequency conversion performed on the second bit sequence.

The transmit end sends the symbol sequence. Correspondingly, the receive end receives, through a wired channel or a wireless channel, a sequence obtained through transmission of the symbol sequence through a channel. The receive end then obtains the to-be-decoded information of the second bit sequence by performing an operation corresponding to the transmit end.

The following describes in detail a rate matching method for the second bit sequence. In a possible implementation, the method shown in FIG. 4 may further include step 404.

404: The transmit end performs rate matching on the second bit sequence.

Generally, a rate matching manner may include at least one of puncturing (puncturing) and shortening (shortening). In addition, generally, a shortened information bit generally corresponds to the last column or the last several columns in the information columns in the check matrix. However, in this embodiment of this application, the shortened information bit includes at least one of an information bit corresponding to the first information column and an information bit corresponding to the information column in the first base graph. In other words, the shortened information bit is not limited to an information bit corresponding to the last information column or the last several information columns in the check matrix. Similarly, a punctured information bit includes at least one of an information bit corresponding to the first information column and an information bit corresponding to the information column in the first base graph.

The following shows two rate matching manners as examples. A rate matching manner 1 may be understood as a rate matching manner based on a code rate, and a rate matching manner 2 may be understood as a rate matching manner based on a code length. For different rate matching manners, the quantity of columns in the first information column may be different. In an example, the quantity of columns in the first information column may be determined based on $K_1$, K, and the target code rate (for example, in the rate matching manner 1 described below). In another example, the quantity of columns in the first information column may be determined based on $K_1$, K, and the lifting size of the check matrix (for example, in the rate matching manner 2 described below).

It may be understood that parameters related to the rate matching manner described below include: the quantity K of information column of the first base graph, a quantity M of rows (which may also be referred to as a quantity of rows corresponding to the maximum code rate supported by the first base graph) and a quantity N of columns (which may also be referred to as a quantity of columns corresponding to the maximum code rate supported by the first base graph) in a core matrix, a quantity P of punctured columns in the first base graph, a quantity $P_1$ of punctured columns in the first information column, a target code length Ni, and a quantity Ki of information bits. K, M, N, P, Ni, and Ki are all positive integers, and $P_1$ is an integer greater than or equal to 0.

**The following describes in detail the rate matching manners provided in this embodiment of this application.**

Rate matching manner 1

The rate matching manner 1 may be understood as a rate matching solution performed for a high code rate. When the target code rate is higher than a code rate of the core matrix of the check matrix (as shown in FIG. 5a, the core parity bit is included, and the maximum code rate supported by the matrix when the parity bit is extended is not included), rate matching may be performed by newly adding an information column. It may be understood that the code rate of the core matrix of the check matrix described in this embodiment of this application is merely an example. For example, a maximum code rate designed for the matrix may be used as an example. For a maximum code rate of 5G, the maximum code rate of 5G is higher than a maximum bit rate of a core part. Therefore, a manner of puncturing the 5th row and the 27th column of a core matrix (including five rows and 27 columns) of the BG1 shown in FIG. 5a to construct the maximum code rate is merely an example.

The rate matching manner 1 is described as follows:

A. Select, based on a code rate $K_1/N_1$, a quantity $K_e$ of information columns to be newly added.

For example, when the code rate $K_1/N_1$ is greater than the maximum code rate supported by the first base graph, $K_e$ is a nonnegative integer satisfying the following formula (1):

$$\frac{K+K_e}{N+K_e-P-P_1} \geq \frac{K_1}{N_1} \quad (1)$$

When $P_1=0$, the foregoing formula (1) may be replaced with formula (2):

$$\frac{K+K_e}{N+K_e-P} \geq \frac{K_1}{N_1} \quad (2)$$

Based on the foregoing formula (1) and formula (2), when the code rate of the first bit sequence is greater than the maximum code rate that can be supported by the first base graph, based on the first base graph, the transmit end may determine the check matrix based on the newly added information column and the indication information. For example, $K_e$=1, $K_e$=2, or $K_e$=3, and $K_e$ may be a positive integer less than or equal to $K_{max}$.

For example, when the code rate $K_1/N_1$ is less than or equal to the maximum code rate supported by the first base graph, $K_e$=0.

For example, if the code rate $\frac{K_1}{N_1} \leq \frac{K}{N-P}$, $K_e$ = 0; and if the code rate $\frac{K_1}{N_1} > \frac{K}{N-P}$, $K_e$ is selected as a minimum nonnegative integer satisfying $\frac{K+K_e}{N+K_e-P} \geq \frac{K_1}{N_1}$. Optionally, if for a maximum quantity $K_e^{max}$ of newly added information columns, $\frac{K+K_e^{max}}{N+K_e^{max}-P} < \frac{K_1}{N_1}$ is still satisfied, $K_e = K_e^{max}$ may be selected.

For example, if the code rate $\frac{K_1}{N_1} \leq \frac{K}{N-P}$, $K_e$ = 0; and the code rate $\frac{K_1}{N_1} > \frac{K}{N-P}$, $K_e$ is selected as a minimum nonnegative integer satisfying $\frac{K+K_e}{N+K_e-P-P_1} \geq \frac{K_1}{N_1}$. Optionally, if for a maximum quantity $K_e^{max}$ of newly added information columns, $\frac{K+K_e^{max}}{N+K_e^{max}-P-P_1} < \frac{K_1}{N_1}$ is still satisfied, $K_e = K_e^{max}$ may be selected.

B. Determine a lifting size $Z_c$ based on the quantity of information columns.

For example, $Z_c$ may be a minimum nonnegative integer satisfying $(K_e + K)Z_c \geq K_1$ in the lifting size list. For descriptions of the lifting size list, refer to the foregoing descriptions of Table 1 and Table 2.

It may be understood that the foregoing step A and step B may be performed when the transmit end performs step 402. For example, before encoding the first bit sequence, the transmit end may first determine $K_e$ and Zc based on the rate matching manner.

C. Shorten an unused information bit.

For example, after encoding the first bit sequence to obtain the second bit sequence, the transmit end may perform shortening processing based on $K_1$, Zc, $K_e$, and K. A $(K_1 + 1)^{th}$ bit to a $(K_e + K)Z_c^{th}$ bit of the information column are shortened.

D. Calculate a quantity of used parity bits.

For example, the transmit end may determine the quantity of parity bits in the second bit sequence based on the code rate and the lifting size of the check matrix. For example, the transmit end may determine, based on Zc, Ni, $K_1$, and P, a quantity of parity bits that need to be used. For example, a quantity $K_2$ of used check columns may be a minimum nonnegative integer satisfying $K_2 * Z_c \geq N_1 - K_1 + P * Z_c$ in a supported quantity of check columns. For another example, for a maximum quantity $K_2^{max}$, $K_2^{max} * Z_c < N_1 - K_1 + P * Z_c$, and therefore, repetition (repetition) processing may be performed on $N_1 - K_1 + P * Z_c - K_2^{max} * Z_c$ bits.

E. Puncture an unused parity bit.

For example, the transmit end may puncture an $(N_1 - K_1 + PZ_c + 1)^{th}$ bit to a $(K_2^{max} Z *_c)^{th}$ (or a $(K_2 * Z_c)^{th}$) bit of the parity bit.

It may be understood that the foregoing step C to step E are merely an example, and a sequence of the foregoing steps is not limited in embodiments of this application.

In the rate matching manner 1, an encoding code rate of the first bit sequence can be effectively increased, and high code rate performance can be improved.

Rate matching manner 2

The rate matching manner 2 may be understood as a rate matching solution performed for a shortened quantity. A more flexible rate matching manner can effectively reduce a performance loss caused by shortening. The rate matching manner 2 is described as follows:

F. Determine $K_1$ based on $K_e$.

For example, $K_e$ is a nonnegative integer satisfying the following formula (3):

$$(K + K_e)Z_c^{K_e} - K_1 \geq 0 \quad (3)$$

For example, $K_e$ may be a minimum nonnegative integer satisfying the foregoing formula (3), or $K_e$ may be a nonnegative integer satisfying the foregoing formula (3).

For example, $K_e$ may be a nonnegative integer that minimizes a difference of $(K + K_e)Z_c^{K_e} - K_1$, where $Z_c^{K_e}$ is minimum $Z_c^{K_e}$ satisfying $(K_e + K)Z_c^{K_e} \geq K_1$ in the lifting size list. Clearly, $Z_c^{K_e}$ is related to $K_e$. Therefore, for each lifting size Zc satisfying the formula (3) in the lifting size list, one quantity $K_e$ may be determined, and therefore, $K_e$ corresponding to minimum Zc may be obtained. In other words, a minimum value of $Z_c^{K_e}$ corresponding to all possible quantities $K_e$ is selected as *Zc* to be used, and corresponding $K_e$ is the quantity of newly added information columns.

G. Shorten an unused information bit.

For example, the transmit end may shorten a $(K_1 + 1)^{th}$ bit to a $(K + K_e)Z_c^{th}$ bit in the information column.

H. Calculate a quantity of used parity bits.

For descriptions of step H, refer to step D. Details are not described herein again.

I. Puncture an unused parity bit.

For descriptions of step I, refer to step E. Details are not described herein again.

It may be understood that the rate matching manner 1 and the rate matching manner 2 are rate matching solutions performed for different code lengths based on the newly added information column. When the target code length is not a product of a lifting size in the lifting size list and the information column, rate matching is performed by newly adding the information column, so that a quantity of shortened bits can be reduced, impact on degree distribution is reduced, and performance is more stable.

It may be understood that numbers A to I of step A to step I are merely used to distinguish between different steps, and do not represent a sequence of the steps.

405: The transmit end sends the symbol sequence obtained through the rate matching on the second bit sequence, and correspondingly, the receive end receives the symbol sequence.

It may be understood that, as described in step 403, after performing rate matching on the second bit sequence, the transmit end may further perform operations such as modulation and frequency conversion.

406: The receive end obtains the to-be-decoded information of the second bit sequence, and performs LDPC decoding on the to-be-decoded information of the second bit sequence based on the check matrix, to obtain the Ki information bits.

It may be understood that before obtaining the to-be-decoded information of the second bit sequence, the receive end may further perform an operation such as demodulation. For example, the to-be-decoded information of the second bit sequence carries the Ki information bits.

Optionally, to ensure that the receive end can correctly perform decoding, the transmit end may further send indication signaling to the receive end. The indication signaling may indicate at least one of the following: $N_1$, $K_1$, the lifting size of the check matrix, and the like. For example, the indication signaling may indicate $N_1$, $K_1$, $K_e$, and the lifting size of the check matrix. For example, the indication signaling may indicate $N_1$, $K_1$, the rate matching manner 1 (or the rate matching manner 2), the lifting size of the check matrix, a punctured position in the second bit sequence, and a shortened position in the second bit sequence. For descriptions of the indication signaling, refer to the foregoing descriptions of the information including the target code rate. Specific content of the indication signaling is not limited in embodiments of this application. Any information that needs to be learned of by the receive end during decoding may be indicated by the transmit end to the receive end. It may be understood that content in the foregoing indication signaling may be defined in the standard, to be stored in memories of the two communication parties during factory setting.

Certainly, the content indicated by the indication signaling described in this embodiment of this application may alternatively be defined in the standard, for example, is set in the two communication parties before delivery. For example, the two communication parties store the content in the indication signaling by using a memory.

For descriptions of the check matrix, refer to the foregoing descriptions. For example, the check matrix is determined based on the correspondence of the first information column and the first base graph. Examples are not listed one by one herein again.

A specific decoding method is not limited in embodiments of this application. For example, the decoding method may be a belief propagation (belief propagation, BP) decoding algorithm or a min-sum (min-sum) decoding algorithm.

The following describes in detail a retransmission start position in embodiments of this application.

Generally, after completing encoding, the transmit end may store an encoded bit sequence in a sending buffer (buffer). The transmit end performs sending based on a position corresponding to RV0. During retransmission, the transmit end performs sending at a position corresponding to RVx (where x=1, 2, or 3). In other words, a retransmission position of the transmit end is related only to a base graph used for encoding. When the base graph is provided, a start position for each time of sending is fixed.

However, in this embodiment of this application, in addition to a base graph (for example, the first base graph) used for encoding, a sending position for retransmission for RVx (where x=1, 2, or 3) is further related to a quantity of columns in a first information column used for initial transmission, for example, related to information such as a code rate of the initial transmission. For example, a quantity of columns in the first base graph is $N_2$, a quantity of punctured columns is $P$, a position for sending a base matrix for RVx is $C_x$, a sending code length is $N_{cb}$, a lifting size is $Z_c$, a quantity of newly added information columns is $K_e$, a quantity of punctured columns in the quantity of newly added information columns is $P_1$, and therefore, a sending position for RVx in this solution is $\lfloor N_{cb}(C_x + K_e - P_1)/Z_c(N_2 - P + K_e - P_1) \rfloor$.

In the foregoing manner, an intersection set between RVx may be reduced based on the newly added information column, so that a retransmission manner is incremental redundancy retransmission as much as possible, to ensure retransmission performance.

It can be learned from the foregoing manner of determining the check matrix based on the correspondence of the first information column and the first base graph, or the foregoing manner of determining the check matrix based on the correspondence of the first information column, the first base graph, and the indication information that, the check matrix in embodiments of this application may be understood as the check matrix constructed based on an initial transmission code rate. A manner of constructing a check matrix is applicable to the two communication parties. In other words, a manner of determining the check matrix by the transmit end needs to be the same as a manner of determining the check matrix by the receive end. In this embodiment of this application, an LDPC code at a high code rate is constructed by using a newly added information column and indication information, so that an edge density is improved. When additional complexity is low, there is a performance gain in a case of a high code rate, and there is no performance loss in a case of a low code rate.

The following describes the encoding method and the decoding method provided in embodiments of this application through simulation.

Emulation result 1

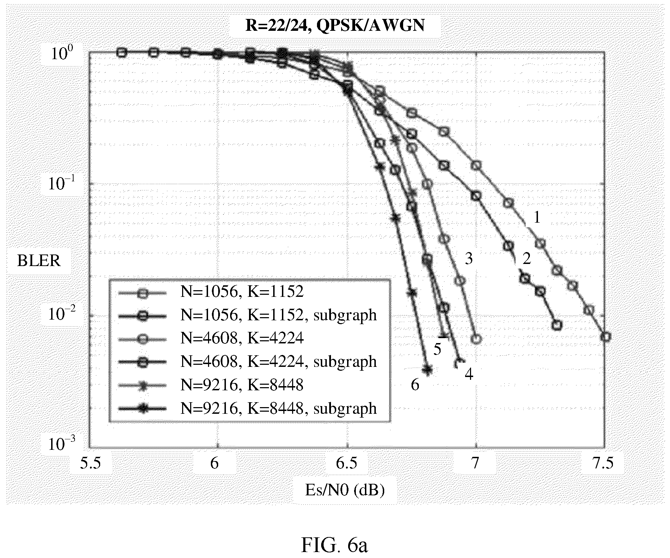

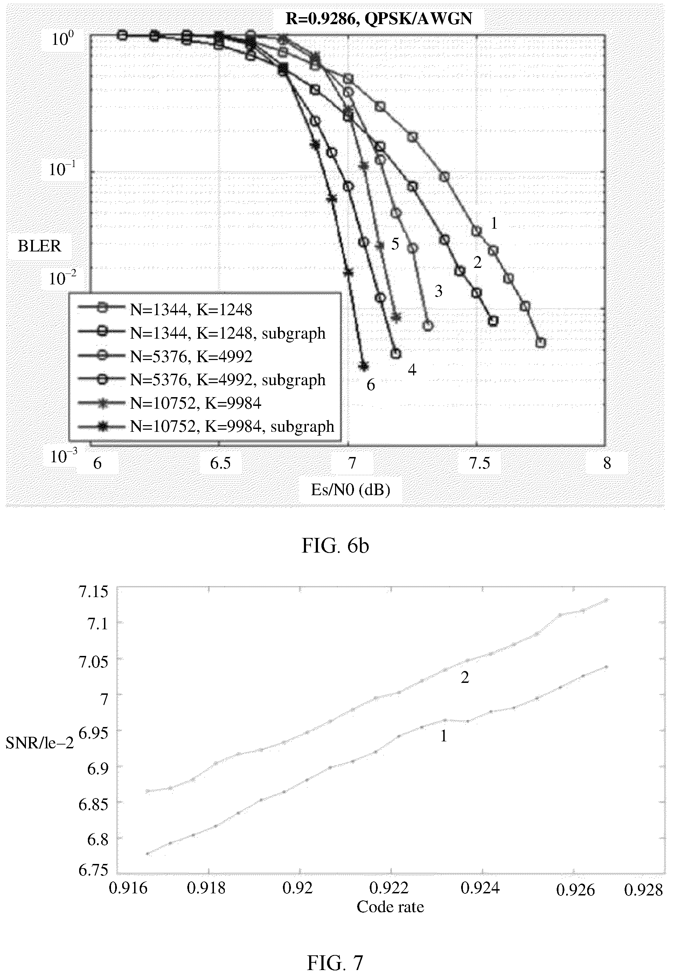

FIG. 6a and FIG. 6b are diagrams of simulation results according to an embodiment of this application. In FIG. 6a and FIG. 6b, a horizontal coordinate represents a signal-to-noise ratio (signal-to-noise ratio, SNR), in a unit of decibels (dB), and a vertical coordinate represents a block error rate (block error rate, BLER). Descriptions of lines in FIG. 6a and FIG. 6b respectively correspond to numerals. For example, descriptions of the first line correspond to a numeral 1 in FIG. 6a and FIG. 6b, descriptions of the second line correspond to a numeral 2 in FIG. 6a and FIG. 6b, and so on. The second line, the fourth line, and the sixth line in FIG. 6a and FIG. 6b respectively correspond to the solutions provided in embodiments of this application. For example, a quantity $K_e$ of columns in the first information column is 4 is used as an example for illustration, that is, four information columns are newly added based on the BG1. It may be understood that code rates in FIG. 6a and FIG. 6b are different. A code rate in FIG. 6a is 22/24, and a code rate in FIG. 6b is 0.9286. It can be learned from FIG. 6a and FIG. 6b that, a better edge density is achieved at a code rate corresponding to a core part of the BG1 and a highest MCS code rate, and performance is improved with a slope to some extent. Similar observations are obtained for each code length. A higher code rate indicates a higher performance gain. A larger code length indicates a closer slope to a decoding threshold, and a best decoding threshold indicates a better edge density.

Emulation result 2

FIG. 7 is a diagram of a simulation result according to an embodiment of this application. A horizontal coordinate in FIG. 7 represents a code rate. For example, the code rate ranges from 0.916 to 0.928. A vertical coordinate in FIG. 7 represents an SNR in a unit of $10^{-2}$ decibels (dB). In FIG. 7, the first line represents corresponding simulation performance when an information column is newly added based on the BG1, and the second line represents simulation performance of a code rate supported by a core part of the BG1. A channel involved in FIG. 7 is an additive white Gaussian noise (additive white Gaussian noise, AWGN) channel, and $K_1$=8448. It can be learned from FIG. 7 that, an information column is newly added, so that a performance gain ranging from 0.1 dB to 0.2 dB can be achieved at a block error rate of 1e-2.

An embodiment of this application provides a solution of constructing an LDPC code at a high code rate based on a newly added information column. Based on a standard storage matrix, two communication parties may additionally store an edge connection relationship between several newly added information columns and a shift value corresponding to the edge connection relationship, so that an LDPC code matrix may be constructed by using different quantities of information columns based on a code rate, a code length, an application scenario, or the like. Optionally, an embodiment of this application further provides a method for adapting to an optimal edge density based on a newly added information column and indication information. Based on a standard storage matrix, two communication parties may additionally store an edge connection relationship between newly added information columns, a corresponding shift value, and indication information, to construct an LDPC code matrix based on a code rate, a code length, an application scenario, or the like.

A communication apparatus provided in embodiments of this application is described below.

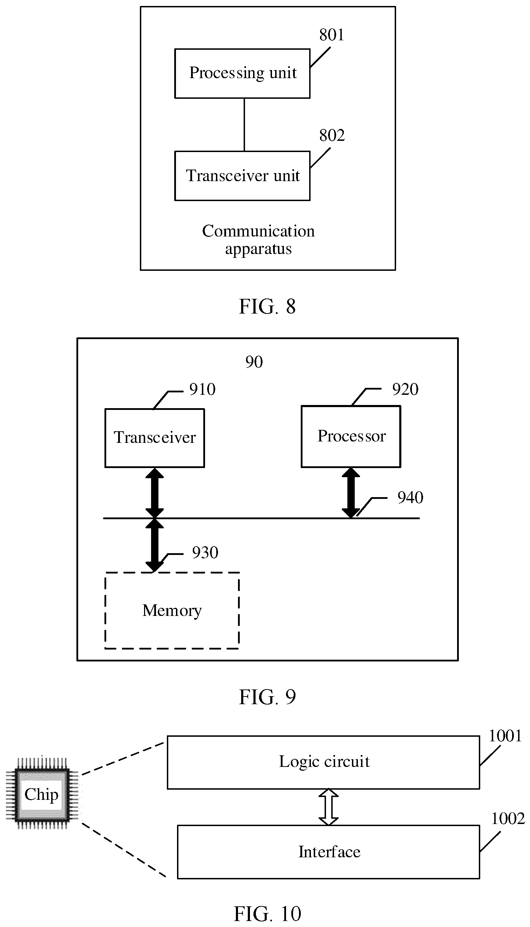

In this application, the communication apparatus is divided into functional modules based on the foregoing method embodiments. For example, the functional modules may be divided corresponding to functions, or two or more functions may be integrated into one processing module. The integrated module may be implemented in a form of hardware, or may be implemented in a form of a software functional module. It should be noted that, in this application, module division is an example, and is merely a logical function division. During actual implementations, another division manner may be used. The following describes in detail the communication apparatus in embodiments of this application with reference to FIG. 8 to FIG. 10.

FIG. 8 is a diagram of a structure of a communication apparatus according to an embodiment of this application. As shown in FIG. 8, the communication apparatus includes a processing unit 801 and a transceiver unit 802. The transceiver unit 802 may implement a corresponding communication function, and the processing unit 801 is configured to process data. For example, the transceiver unit 802 may also be referred to as a communication interface, a communication unit, or the like.

In some embodiments of this application, the communication apparatus may be configured to perform an action performed by the transmit end in the foregoing method embodiments. In this case, the communication apparatus may be the transmit end or a component (such as a chip or a system) that can be configured at the transmit end. The transceiver unit 802 is configured to perform a transmitting and receiving related operation of the transmit end in the foregoing method embodiments. The processing unit 801 is configured to perform a processing related operation of the transmit end in the foregoing method embodiments. The communication apparatus may be configured to perform the steps, the functions, or the like performed by the transmit end in the foregoing method embodiments.

The processing unit 801 is configured to obtain a first bit sequence, where the first bit sequence includes Ki information bits, and Ki is a positive integer.

The processing unit 801 is further configured to perform LDPC encoding on the first bit sequence based on a check matrix, to obtain a second bit sequence, where the check matrix is determined based on a correspondence of a first information column and a first base graph, and a quantity of columns in the first information column is determined based on the quantity Ki of information bits and a quantity K of information columns in the first base graph.

The processing unit 801 is further configured to output the second bit sequence.

It may be understood that, that the processing unit outputs the second bit sequence may be understood as follows: The processing unit may send the second bit sequence to another component by using the transceiver unit (for example, send the second bit sequence to an apparatus for modulation, or send the second bit sequence to an apparatus for frequency conversion), or the processing unit sends a modulation symbol of the second bit sequence to a receive end by using the transceiver unit, or the like. Details are not listed in this embodiment of this application.

In a possible implementation, the processing unit 801 is further configured to perform rate matching on the second bit sequence, where a shortened information bit includes at least one of an information bit corresponding to the first information column and an information bit corresponding to an information column in the first base graph, and a punctured information bit includes at least one of an information bit corresponding to the first information column and an information bit corresponding to an information column in the first base graph.

Optionally, the communication apparatus may further include a storage unit. The storage unit may be configured to store instructions and/or data. The processing unit 801 may read the instructions and/or the data in the storage unit, so that the communication apparatus implements the foregoing method embodiments. For example, the storage unit may be configured to store at least one of the following: a correspondence of the first information column, the first base graph, a second base graph, a reliability order, indication information, and the like.

It may be understood that the specific descriptions of the transceiver unit and the processing unit described in this embodiment of this application are merely examples. For specific functions, performed steps, or the like of the transceiver unit and the processing unit, refer to the foregoing method embodiments. Details are not described herein again. The foregoing descriptions of the processing unit and the transceiver unit are merely examples. For descriptions of the foregoing terms, refer to the method embodiments. For descriptions of the first bit sequence, the second bit sequence, the first information column, the indication information, and the like, refer to the foregoing method embodiments. Details are not described herein again.

Still refer to FIG. 8. In some other embodiments of this application, the communication apparatus may be configured to perform an action performed by the receive end in the foregoing method embodiments. In this case, the communication apparatus may be the receive end or a component that can be configured at the receive end. The transceiver unit 802 is configured to perform a transmitting and receiving related operation of the receive end in the foregoing method embodiments. The processing unit 801 is configured to perform a processing related operation of the receive end in the foregoing method embodiments. In other words, the communication apparatus may be configured to perform the steps, the functions, or the like performed by the receive end in the foregoing method embodiments.

The processing unit 801 is configured to obtain to-be-decoded information of a second bit sequence.

The processing unit 801 is further configured to perform LDPC decoding on the to-be-decoded information of the second bit sequence based on a check matrix, where the check matrix is determined based on a correspondence of a first information column and a first base graph, and a quantity of columns in the first information column is determined based on a quantity Ki of information bits and a quantity K of information columns in the first base graph.

For example, the transceiver unit 802 may be configured to receive a modulation symbol; and the processing unit 801 is configured to obtain to-be-decoded information of a second bit sequence based on the input modulation symbol.

Optionally, the communication apparatus may further include a storage unit. The storage unit may be configured to store instructions and/or data. The processing unit 801 may read the instructions and/or the data in the storage unit, so that the communication apparatus implements the foregoing method embodiments. For example, the storage unit may be configured to store at least one of the following: a correspondence of the first information column, the first base graph, a second base graph, a reliability order, indication information, and the like.

It may be understood that the specific descriptions of the transceiver unit and the processing unit described in this embodiment of this application are merely examples. For specific functions, performed steps, or the like of the transceiver unit and the processing unit, refer to the foregoing method embodiments. Details are not described herein again. It may be understood that the foregoing descriptions of the processing unit and the transceiver unit are merely examples. For descriptions of the foregoing terms, refer to the method embodiments. For descriptions of the first bit sequence, the second bit sequence, the first information column, the indication information, and the like, refer to the foregoing method embodiments. Details are not described herein again.

The foregoing describes the communication apparatus in embodiments of this application. The following describes possible product forms of the communication apparatus. It should be understood that any product in any form that has a function of the communication apparatus in FIG. 8 is within the protection scope of embodiments of this application.

In a possible implementation, in the communication apparatus shown in FIG. 8, the processing unit 801 may be one or more processors, and the transceiver unit 802 may be a transceiver, or the transceiver unit 802 may be a sending unit and a receiving unit. The sending unit may be a transmitter, and the receiving unit may be a receiver. The sending unit and the receiving unit are integrated into one component, for example, a transceiver. In embodiments of this application, the processor and the transceiver may be coupled, or the like. A manner of connection between the processor and the transceiver is not limited in embodiments of this application. In a process of performing the foregoing method, a process of sending information in the foregoing method may be understood as a process of outputting the information by the processor. When outputting the information, the processor outputs the information to the transceiver, so that the transceiver transmits the information. After the information is output by the processor, other processing may further need to be performed on the information before the information arrives at the transceiver. Similarly, a process of receiving information in the foregoing method may be understood as a process of receiving the input information by the processor. When the processor receives the input information, the transceiver receives the information, and inputs the information into the processor. Still further, after the transceiver receives the information, other processing may need to be performed on the information before the information is input into the processor.

As shown in FIG. 9, the communication apparatus 90 includes one or more processors 920 and a transceiver 910.

For example, when the communication apparatus is configured to perform the step, the method, or the function performed by the transmit end, the processor 920 is configured to obtain a first bit sequence; the processor 920 is further configured to perform LDPC encoding on the first bit sequence based on a check matrix, to obtain a second bit sequence; and the processor 920 is further configured to output the second bit sequence.

In a possible implementation, the processor 920 is further configured to perform rate matching on the second bit sequence.

In a possible implementation, the transceiver 910 is configured to send indication signaling, where the indication signaling is used for indicating at least one of the following: Ni, $K_1$, $K_2$, a lifting size of the check matrix, a shortened position in the second bit sequence, and a puncturing position in the second bit sequence.

For example, when the communication apparatus is configured to perform the step, the method, or the function performed by the receive end, the processor 920 is configured to obtain to-be-decoded information of the second bit sequence. The processor 920 is further configured to perform LDPC decoding on the to-be-decoded information of the second bit sequence based on the check matrix, to obtain Ki information bits.

In a possible implementation, the transceiver 910 is configured to receive indication signaling, where the indication signaling is used for indicating at least one of the following: Ni, $K_1$, $K_2$, a lifting size of the check matrix, a shortened position in the second bit sequence, and a puncturing position in the second bit sequence.

It may be understood that for specific descriptions of the processor and the transceiver, refer to descriptions of the processing unit and the transceiver unit shown in FIG. 8. Details are not described herein again. For descriptions of the foregoing terms, refer to the method embodiments. For descriptions of the first bit sequence, the second bit sequence, the first information column, the indication information, and the like, refer to the foregoing method embodiments. Details are not described herein again.

In implementations of the communication apparatus shown in FIG. 9, the transceiver may include a receiver and a transmitter. The receiver is configured to perform a receiving function (or operation), and the transmitter is configured to perform a transmitting function (or operation). The transceiver is configured to communicate with another device/apparatus through a transmission medium.

Optionally, the communication apparatus 90 may further include one or more memories 930, configured to store program instructions and/or data. The memory 930 is coupled to the processor 920. The coupling in this embodiment of this application may be an indirect coupling or a communication connection between apparatuses, units, or modules in an electrical form, a mechanical form, or another form, and is used for information exchange between the apparatuses, the units, or the modules. The processor 920 may operate in collaboration with the memory 930. The processor 920 may execute the program instructions stored in the memory 930. Optionally, at least one of the one or more memories may be included in the processor. Optionally, the one or more memories may be configured to store the first base graph, and the correspondence of the first information column in embodiments of this application, or store the second base graph in embodiments of this application.

In this embodiment of this application, a specific connection medium among the transceiver 910, the processor 920 and the memory 930 is not limited. In this embodiment of this application, in FIG. 9, the memory 930, the processor 920, and the transceiver 910 are connected to each other by using a bus 940. The bus is represented by using a thick line in FIG. 9. A manner of connection between other components is only schematically described, but is not used as a limitation. The bus may be classified into an address bus, a data bus, a control bus, and the like. For ease of representation, only one thick line is used to represent the bus in FIG. 9, but this does not mean that there is only one bus or only one type of bus.

In this embodiment of this application, the processor may be a general-purpose processor, a digital signal processor, an application-specific integrated circuit, a field programmable gate array or another programmable logic device, a discrete gate or transistor logic device, a discrete hardware component, or the like. The processor can implement or execute the methods, the steps, and the logical block diagrams disclosed in embodiments of this application. The general-purpose processor may be a microprocessor or any conventional processor or the like. The steps of the methods disclosed in combination with embodiments of this application may be directly implemented by a hardware processor, or may be implemented by using a combination of hardware and software modules in the processor, or the like.

In this embodiment of this application, the memory may include, but is not limited to, a nonvolatile memory such as a hard disk drive (hard disk drive, HDD) or a solid-state drive (solid-state drive, SSD), a random access memory (Random Access Memory, RAM), an erasable programmable read-only memory (Erasable Programmable ROM, EPROM), a read-only memory (Read-Only Memory, ROM), or a portable read-only memory (Compact Disc Read-Only Memory, CD-ROM). The memory is any storage medium that can be used to carry or store program code in a form of an instruction or a data structure and that can be read and/or written by a computer (for example, the communication apparatus described in this application). However, this application is not limited thereto. The memory in embodiments of this application may alternatively be a circuit or any other apparatus that can implement a storage function, and is configured to store the program instructions and/or the data.

For example, the processor 920 is mainly configured to process a communication protocol and communication data, control the entire communication apparatus, execute a software program, and process data of the software program. The memory 930 is mainly configured to store a software program and data. The transceiver 910 may include a control circuit and an antenna. The control circuit is mainly configured to convert a baseband signal and a radio frequency signal and process the radio frequency signal. The antenna is mainly configured to receive and send a radio frequency signal in a form of an electromagnetic wave. The input/output apparatus, such as a touchscreen, a display, or a keyboard, is mainly configured to: receive data input by a user and output data to the user.

After the communication apparatus is powered on, the processor 920 may read the software program from the memory 930, interpret and execute instructions of the software program, and process data of the software program. When data needs to be sent wirelessly, the processor 920 performs baseband processing on the to-be-sent data, and then outputs a baseband signal to a radio frequency circuit. The radio frequency circuit performs radio frequency processing on the baseband signal, and then sends, by using the antenna, a radio frequency signal in an electromagnetic wave form. When data is sent to the communication apparatus, the radio frequency circuit receives the radio frequency signal by using the antenna, converts the radio frequency signal into a baseband signal, and outputs the baseband signal to the processor 920. The processor 920 converts the baseband signal into data and processes the data.

In another implementation, the radio frequency circuit and the antenna may be disposed independent of the processor that performs baseband processing. For example, in a distributed scenario, the radio frequency circuit and the antenna may be remotely disposed independent of the communication apparatus.

It may be understood that the communication apparatus described in this embodiment of this application may further have more components and the like than those in FIG. 9. This is not limited in embodiments of this application. The methods performed by the processor and the transceiver are merely examples. For specific steps performed by the processor and the transceiver, refer to the methods described above.

In another possible implementation, in the communication apparatus shown in FIG. 8, the processing unit 801 may be one or more logic circuits, and the transceiver unit 802 may be an input/output interface, or may be referred to as a communication interface, an interface circuit, an interface, or the like. Alternatively, the transceiver unit 802 may be a sending unit and a receiving unit. The sending unit may be an output interface, and the receiving unit may be an input interface. The sending unit and the receiving unit are integrated into one unit, for example, an input/output interface. As shown in FIG. 10, the communication apparatus shown in FIG. 10 includes a logic circuit 1001 and an interface 1002. That is, the processing unit 801 may be implemented by using the logic circuit 1001, and the transceiver unit 802 may be implemented by using the interface 1002. The logic circuit 1001 may be a chip, a processing circuit, an integrated circuit, a system on chip (system on chip, SoC), or the like. The interface 1002 may be a communication interface, an input/output interface, a pin, or the like. For example, FIG. 10 shows an example in which the communication apparatus is a chip. The chip includes a logic circuit 1001 and an interface 1002.

In this embodiment of this application, the logic circuit and the interface may be coupled to each other. A specific manner of connection between the logic circuit and the interface is not limited in embodiments of this application.

For example, when the communication apparatus is configured to perform the method, the function, or the step performed by the transmit end, the logic circuit 1001 is configured to obtain a first bit sequence, the logic circuit 1001 is further configured to perform LDPC encoding on the first bit sequence based on a check matrix, to obtain a second bit sequence; and the interface 1002 is configured to output the second bit sequence.

It may be understood that the interface may output the second bit sequence, so that another component in the transmit end processes the second bit sequence. Alternatively, the interface is configured to output a symbol sequence obtained after operations such as rate matching, modulation, and frequency conversion are performed on the second bit sequence.

Optionally, the communication apparatus may further include a memory. The memory may be configured to store the first base graph and the correspondence of the first information column, or configured to store the second base graph.

In a possible implementation, the logic circuit 1001 is further configured to perform rate matching on the second bit sequence.

In a possible implementation, the interface 1002 is configured to output indication signaling, where the indication signaling is used for indicating at least one of the following: Ni, $K_1$, $K_2$, a lifting size of the check matrix, a shortened position in the second bit sequence, and a puncturing position in the second bit sequence.

For example, when the communication apparatus is configured to perform the method, the function, or the step performed by the receive end, the logic circuit 1001 is configured to obtain to-be-decoded information of the second bit sequence, and the logic circuit 1001 is further configured to perform LDPC decoding on the to-be-decoded information of the second bit sequence based on the check matrix, to obtain Ki information bits.

It may be understood that the interface 1002 may be configured to input a signal such as a modulation symbol communicated through a channel, and then a logic circuit 1001 may process the signal to obtain the to-be-decoded information of the second bit sequence. Certainly, the logic circuit that processes the signal may be the same as or different from the logic circuit that performs the LDPC decoding. This is not limited in embodiments of this application.

In a possible implementation, the interface 1002 is configured to input indication signaling, where the indication signaling is used for indicating at least one of the following: Ni, $K_1$, $K_2$, a lifting size of the check matrix, a shortened position in the second bit sequence, and a puncturing position in the second bit sequence.

For descriptions of the foregoing terms, refer to the method embodiments. For descriptions of the first bit sequence, the second bit sequence, the first information column, the indication information, and the like, refer to the foregoing method embodiments. Details are not described herein again.

It may be understood that the communication apparatus described in embodiments of this application may implement the methods provided in embodiments of this application in a form of hardware, or may implement the methods provided in embodiments of this application in a form of software. This is not limited in embodiments of this application.

For specific implementations of the embodiments shown in FIG. 10, refer to the foregoing embodiments. Details are not described herein again.

An embodiment of this application further provides a wireless communication system. The wireless communication system includes a transmit end and a receive end. The transmit end and the receive end may be configured to perform the methods in any one of the foregoing embodiments. Alternatively, for the transmit end and the receive end, refer to the communication apparatuses shown in FIG. 8 to FIG. 10.

In addition, this application further provides a computer program. The computer program is used to implement operations and/or processing performed by the transmit end in the methods provided in this application.

This application further provides a computer program. The computer program is used to implement operations and/or processing performed by the receive end in the methods provided in this application.

This application further provides a computer-readable storage medium. The computer-readable storage medium stores computer code. When the computer code is run on a computer, the computer is enabled to perform operations and/or processing performed by the transmit end in the methods provided in this application.

This application further provides a computer-readable storage medium. The computer-readable storage medium stores computer code. When the computer code is run on a computer, the computer is enabled to perform operations and/or processing performed by the receive end in the methods provided in this application.

This application further provides a computer program product. The computer program product includes computer code or a computer program. When the computer code or the computer program runs on a computer, operations and/or processing performed by the transmit end in the methods provided in this application are/is performed.

This application further provides a computer program product. The computer program product includes computer code or a computer program. When the computer code or the computer program runs on a computer, operations and/or processing performed by the receive end in the methods provided in this application are/is performed.

In the several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces, indirect couplings or communication connections between the apparatuses or units, or electrical connections, mechanical connections, or connections in other forms.

The units described as separate parts may or may not be physically separate, and parts displayed as units may or may not be physical units, may be located in one position, or may be distributed on a plurality of network units. Some or all of the units may be selected based on an actual requirement to implement the technical effect of the solutions provided in embodiments of this application.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technologies, or all or some of the technical solutions may be implemented in a form of a software product. The computer software product is stored in a readable storage medium and includes a plurality of instructions for instructing a computer device (which may be a personal computer, a server, a network device, or the like) to perform all or some of the steps of the methods described in embodiments of this application. The readable storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An encoding method, wherein the method comprises:

   obtaining a first bit sequence, wherein the first bit sequence comprises Ki information bits, and $K_1$ is a positive integer;
   performing low-density parity-check LDPC encoding on the first bit sequence based on a check matrix, to obtain a second bit sequence, wherein the check matrix is determined based on a correspondence of a first information column and a first base graph, and a quantity of columns in the first information column is determined based on a quantity Ki of information bits and a quantity K of information columns in the first base graph; and
   outputting the second bit sequence.

2. The method according to claim 1, wherein the method further comprises:
   performing rate matching on the second bit sequence, wherein a shortened information bit comprises at least one of an information bit corresponding to the first information column and an information bit corresponding to an information column in the first base graph, and a punctured information bit comprises at least one of an information bit corresponding to the first information column and an information bit corresponding to an information column in the first base graph.

3. A decoding method, wherein the method comprises:

obtaining to-be-decoded information of a second bit sequence, wherein the to-be-decoded information of the second bit sequence carries Ki information bits; and

performing low-density parity-check LDPC decoding on the to-be-decoded information of the second bit sequence based on a check matrix, to obtain the Ki information bits, wherein the check matrix is determined based on a correspondence of a first information column and a first base graph, and a quantity of columns in the first information column is determined based on a quantity Ki of information bits and a quantity K of information columns in the first base graph.

4. The method according to any one of claims 1 to 3, wherein that the quantity of columns in the first information column is determined based on the quantity Ki of information bits and the quantity K of information columns in the first base graph comprises:
the quantity of columns in the first information column is determined based on the quantity Ki of information bits, the quantity K of information columns in the first base graph, and a target code rate.

5. The method according to any one of claims 1 to 4, wherein the quantity $K_e$ of columns in the first information column is a nonnegative integer satisfying the following formula:

$$\frac{K+K_e}{N+K_e-P} \geq \frac{K_1}{N_1},$$

wherein

N is a total quantity of information columns and core check columns that correspond to a maximum code rate $R_0$ supported by the first base graph, P is a quantity of punctured columns in the first base graph, and $N_1$ is a target code length.

6. The method according to any one of claims 1 to 5, wherein that the quantity of columns in the first information column is determined based on the quantity Ki of information bits and the quantity K of information columns in the first base graph comprises:
the quantity of columns in the first information column is determined based on the quantity Ki of information bits, the quantity K of information columns in the first base graph, and a lifting size of the check matrix.

7. The method according to any one of claims 1 to 6, wherein the quantity $K_e$ of columns in the first information column is a nonnegative integer satisfying the following formula:

$$(K + K_e)Z_c^{K_e} - K_1 \geq 0,$$

wherein

$Z_c^{K_e}$ is the lifting size of the check matrix.

8. The method according to any one of claims 1 to 7, wherein that the check matrix is determined based on the correspondence of the first information column and the first base graph comprises:
the check matrix is determined based on the correspondence of the first information column, the first base graph, and indication information, wherein the indication information indicates to change a value of at least one node in the first base graph.

9. The method according to claim 8, wherein the indication information is determined based on the target code rate.

10. The method according to claim 8 or 9, wherein the indication information is determined based on a reliability order, and the reliability order is determined based on a decoding threshold.

11. The method according to any one of claims 8 to 10, wherein the indication information does not comprise a value corresponding to a variable node of an extended part whose degree is 1 in the first base graph.

12. The method according to any one of claims 1 to 11, wherein a retransmission start position is determined based on at least one of the target code rate and the quantity of columns in the first information column.

13. A communication apparatus, wherein the apparatus comprises:

   a processing unit, configured to obtain a first bit sequence, wherein the first bit sequence comprises Ki information bits, and Ki is a positive integer, wherein
   the processing unit is further configured to perform low-density parity-check LDPC encoding on the first bit sequence based on a check matrix, to obtain a second bit sequence, wherein the check matrix is determined based on a correspondence of a first information column and a first base graph, and a quantity of columns in the first information column is determined based on the quantity Ki of information bits and a quantity K of information columns in the first base graph; and
   the processing unit is further configured to output the second bit sequence.

14. The apparatus according to claim 13, wherein the processing unit is further configured to perform rate matching on the second bit sequence, wherein a shortened information bit comprises at least one of an information bit corresponding to the first information column and an information bit corresponding to an information column in the first base graph, and a punctured information bit comprises at least one of an information bit corresponding to the first information column and an information bit corresponding to an information column in the first base graph.

15. A communication apparatus, wherein the apparatus comprises:

   a processing unit, configured to obtain to-be-decoded information of a second bit sequence, wherein the to-be-decoded information of the second bit sequence carries Ki information bits, wherein
   the processing unit is further configured to perform low-density parity-check LDPC decoding on the to-be-decoded information of the second bit sequence based on a check matrix, to obtain the Ki information bits, wherein the check matrix is determined based on a correspondence of a first information column and a first base graph, and a quantity of columns in the first information column is determined based on a quantity Ki of information bits and a quantity K of information columns in the first base graph.

16. The apparatus according to any one of claims 13 to 15, wherein that the quantity of columns in the first information column is determined based on the quantity Ki of information bits and the quantity K of information columns in the first base graph comprises:
   the quantity of columns in the first information column is determined based on the quantity Ki of information bits, the quantity K of information columns in the first base graph, and a target code rate.

17. The apparatus according to any one of claims 13 to 16, wherein the quantity $K_e$ of columns in the first information column is a nonnegative integer satisfying the following formula:

$$\frac{K+K_e}{N+K_e-P} \geq \frac{K_1}{N_1},$$

   wherein
   N is a total quantity of information columns and core check columns that correspond to a maximum code rate $R_0$ supported by the first base graph, P is a quantity of punctured columns in the first base graph, and $N_1$ is a target code length.

18. The apparatus according to any one of claims 13 to 17, wherein that the quantity of columns in the first information column is determined based on the quantity Ki of information bits and the quantity K of information columns in the first base graph comprises:
   the quantity of columns in the first information column is determined based on the quantity Ki of information bits, the quantity K of information columns in the first base graph, and a lifting size of the check matrix.

19. The apparatus according to any one of claims 13 to 18, wherein the quantity $K_e$ of columns in the first information column is a nonnegative integer satisfying the following formula:

$$(K + K_e)Z_c^{K_e} - K_1 \geq 0,$$

wherein

$Z_c^{K_e}$ is the lifting size of the check matrix.

20. The apparatus according to any one of claims 13 to 19, wherein that the check matrix is determined based on the correspondence of the first information column and the first base graph comprises:
the check matrix is determined based on the correspondence of the first information column, the first base graph, and indication information, wherein the indication information indicates to change a value of at least one node in the first base graph.

21. The apparatus according to claim 20, wherein the indication information is determined based on the target code rate.

22. The apparatus according to claim 20 or 21, wherein the indication information is determined based on a reliability order, and the reliability order is determined based on a decoding threshold.

23. The apparatus according to any one of claims 20 to 22, wherein the indication information does not comprise a value corresponding to a variable node of an extended part whose degree is 1 in the first base graph.

24. The apparatus according to any one of claims 13 to 23, wherein a retransmission start position is determined based on at least one of the target code rate and the quantity of columns in the first information column.

25. A communication apparatus, comprising a processor and a memory, wherein

the processor is configured to store computer instructions; and
the processor is configured to execute the computer instructions, to perform the method according to any one of claims 1, 2, and 4 to 12, or perform the method according to any one of claims 3 to 12.

26. A communication apparatus, comprising a logic circuit and an interface, wherein the logic circuit is coupled to the interface; and
the interface is configured to input to-be-processed data, the logic circuit processes the to-be-processed data according to the method according to any one of claims 1 to 12, to obtain processed data, and the interface is configured to output the processed data.

27. A computer-readable storage medium, wherein the computer-readable storage medium is configured to store instructions, and when the instructions are executed, the method according to any one of claims 1 to 12 is performed.

28. A computer program product, wherein when instructions are run on a computer, the method according to any one of claims 1 to 12 is performed.

FIG. 1

FIG. 2a

EP 4 625 909 A1

Information column | Four core check columns | Check column

A   B   C

D   E

FIG. 2b

| MCS index (Index) $I_{MCS}$ | Modulation order (Modulation order) $Q_m$ | Target code rate (Target code rate) Rx 1024 | Spectral efficiency (Spectral efficiency) |
|---|---|---|---|
| 0 | q | 240/q | 0.2344 |
| 1 | q | 314/q | 0.3066 |
| 2 | 2 | 193 | 0.3770 |
| 3 | 2 | 251 | 0.4902 |
| 4 | 2 | 308 | 0.6016 |
| 5 | 2 | 379 | 0.7402 |
| 6 | 2 | 449 | 0.8770 |
| 7 | 2 | 526 | 1.0273 |
| 8 | 2 | 602 | 1.1758 |
| 9 | 2 | 679 | 1.3262 |
| 10 | 4 | 340 | 1.3281 |
| 11 | 4 | 378 | 1.4766 |
| 12 | 4 | 434 | 1.6953 |
| 13 | 4 | 490 | 1.9141 |
| 14 | 4 | 553 | 2.1602 |
| 15 | 4 | 616 | 2.4063 |
| 16 | 4 | 658 | 2.5703 |
| 17 | 6 | 466 | 2.7305 |
| 18 | 6 | 517 | 3.0293 |
| 19 | 6 | 567 | 3.3223 |
| 20 | 6 | 616 | 3.6094 |
| 21 | 6 | 666 | 3.9023 |
| 22 | 6 | 719 | 4.2129 |
| 23 | 6 | 772 | 4.5234 |
| 24 | 6 | 822 | 4.8164 |
| 25 | 6 | 873 | 5.1152 |
| 26 | 6 | 910 | 5.3320 |
| 27 | 6 | 948 | 5.5547 |
| 28 | q | Reserved (reserved) | |
| 29 | 2 | Reserved (reserved) | |
| 30 | 4 | Reserved (reserved) | |
| 31 | 6 | Reserved (reserved) | |

FIG. 3a

```
┌─────────────────────┐                    ┌─────────────────────┐
│    Transmit end     │                    │    Receive end      │
└─────────────────────┘                    └─────────────────────┘
          │                                           │
┌─────────────────────────────┐  401                  │
│ Obtain a first bit sequence, │   ╱                   │
│ where the first bit sequence │ ╱                     │
│ includes K₁ information bits, │                      │
│ and K₁ is a positive integer │                       │
└─────────────────────────────┘                       │
          │                                           │
┌─────────────────────────────┐  402                  │
│  Perform LDPC encoding on    │                       │
│ the first bit sequence based │                       │
│  on a check matrix, to obtain │                      │
│ a second bit sequence, where │  ╱                    │
│ the check matrix is determined │                     │
│    based on a correspondence  │                      │
│   of a first information      │                       │
│ column and a first base graph,│                      │
│ and a quantity of columns in  │                       │
│ the first information column  │                       │
│  is determined based on a     │                       │
│  quantity K₁ of information   │                        │
│   bits and a quantity K of    │                       │
│ information columns in the    │                        │
│     first base graph          │                       │
└─────────────────────────────┘                       │
          │                                           │
┌─────────────────────────────┐  403                  │
│ Output the second bit sequence│  ╱                   │
└─────────────────────────────┘                       │
          │                                           │
┌ ─ ─ ─ ─ ─ ─ ─ ─ ─ ─ ─ ─ ─ ┐  404                   │
│ Perform rate matching on the │   ╱                   │
│    second bit sequence       │                        │
└ ─ ─ ─ ─ ─ ─ ─ ─ ─ ─ ─ ─ ─ ┘                        │
          │                                           │
          │   Symbol sequence obtained by             │
          │  performing rate matching on the  405     │
          │      second bit sequence           ╱      │
          │──────────────────────────────────────────▶│
          │                                           │
          │                              ┌────────────────────────────┐ 406
          │                              │ Obtain to-be-decoded         │ ╱
          │                              │ information of the second bit │
          │                              │ sequence, and perform LDPC   │
          │                              │ decoding on the to-be-decoded │
          │                              │ information of the second bit │
          │                              │ sequence based on the check  │
          │                              │ matrix, to obtain the K₁      │
          │                              │    information bits          │
          │                              └────────────────────────────┘
          │                                           │
```

FIG. 4

Puncture

Newly added information column

FIG. 5a

EP 4 625 909 A1

Newly added information column

FIG. 5b

FIG. 5c

FIG. 6a

**R=0.9286, QPSK/AWGN**

Legend:
- N=1344, K=1248
- N=1344, K=1248, subgraph
- N=5376, K=4992
- N=5376, K=4992, subgraph
- N=10752, K=9984
- N=10752, K=9984, subgraph

FIG. 6b

FIG. 7

801

Processing unit

802

Transceiver unit

Communication
apparatus

FIG. 8

90

910

Transceiver

920

Processor

940

930

Memory

FIG. 9

1001

Logic circuit

1002

Interface

Chip

FIG. 10

## INTERNATIONAL SEARCH REPORT

| International application No. |
|---|
| **PCT/CN2022/138944** |

**A. CLASSIFICATION OF SUBJECT MATTER**

H04L27/00(2006.01)i; H04L1/00(2006.01)i; H03M13/11(2006.01)i

According to International Patent Classification (IPC) or to both national classification and IPC

**B. FIELDS SEARCHED**

Minimum documentation searched (classification system followed by classification symbols)

IPC:H04L H03M

Documentation searched other than minimum documentation to the extent that such documents are included in the fields searched

Electronic data base consulted during the international search (name of data base and, where practicable, search terms used)

CNTXT, ENTXT, ENTXTC, VEN, CJFD, 3GPP, CNKI, IEEE: 低密度奇偶校验, 校验矩阵, 编码, 译码, 基图, 基模图, 基础矩阵, 基矩阵, 加, 增, 列, 码率, LDPC, check matrix, coding, encode, decode, base graph, basegraph, BG, add+, column, code rate.

**C. DOCUMENTS CONSIDERED TO BE RELEVANT**

| Category* | Citation of document, with indication, where appropriate, of the relevant passages | Relevant to claim No. |
|---|---|---|
| A | CN 108347299 A (HUAWEI TECHNOLOGIES CO., LTD.) 31 July 2018 (2018-07-31) description, paragraphs 262-275, 370-372, and 434-436, and figures 1-4 and 9-10 | 1-28 |
| A | CN 110289933 A (HUAWEI TECHNOLOGIES CO., LTD.) 27 September 2019 (2019-09-27) entire document | 1-28 |
| A | CN 108988870 A (CHINA ACADEMY OF TELECOMMUNICATIONS TECHNOLOGY) 11 December 2018 (2018-12-11) entire document | 1-28 |
| A | US 2020177303 A1 (HUAWEI TECHNOLOGIES CO., LTD.) 04 June 2020 (2020-06-04) entire document | 1-28 |
| A | US 2021013901 A1 (ZTE CORP.) 14 January 2021 (2021-01-14) entire document | 1-28 |

| ✓ | Further documents are listed in the continuation of Box C. | ✓ | See patent family annex. |
|---|---|---|---|

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 July 2023** | **13 August 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2022/138944** |

| C. | DOCUMENTS CONSIDERED TO BE RELEVANT | |
| --- | --- | --- |
| Category* | Citation of document, with indication, where appropriate, of the relevant passages | Relevant to claim No. |
| A | 柴蓉 等 (CHAI, Rong et al.). "面向5G新空口技术的LDPC码标准化研究进展 (Standardization of 5G New Radio Technology Oriented LDPC Code)" 重庆邮电大学学报(自然科学版) (Journal of Chongqing University of Posts and Telecommunications(Natural Science Edition)), Vol. 30, No. 05, 15 October 2018 (2018-10-15), entire document | 1-28 |
| A | INTEL CORP. "LDPC design for NR data channel" 3GPP TSG RAN WG1 Meeting #87 R1-1612586, 06 November 2016 (2016-11-06), entire document | 1-28 |

Form PCT/ISA/210 (second sheet) (July 2022)

**INTERNATIONAL SEARCH REPORT**
Information on patent family members

International application No.

**PCT/CN2022/138944**

| Patent document cited in search report | | | Publication date (day/month/year) | Patent family member(s) | | | Publication date (day/month/year) |
|---|---|---|---|---|---|---|---|
| CN | 108347299 | A | 31 July 2018 | WO | 2018137544 | A1 | 02 August 2018 |
| | | | | CN | 108347299 | B | 05 February 2021 |
| CN | 110289933 | A | 27 September 2019 | WO | 2019179404 | A1 | 26 September 2019 |
| | | | | CN | 110289933 | B | 12 April 2022 |
| CN | 108988870 | A | 11 December 2018 | WO | 2018219001 | A1 | 06 December 2018 |
| | | | | CN | 108988870 | B | 31 August 2021 |
| US | 2020177303 | A1 | 04 June 2020 | EP | 3657707 | A1 | 27 May 2020 |
| | | | | EP | 3657707 | A4 | 29 July 2020 |
| | | | | US | 11368241 | B2 | 21 June 2022 |
| | | | | WO | 2019029690 | A1 | 14 February 2019 |
| | | | | CN | 109391367 | A | 26 February 2019 |
| | | | | CN | 109391367 | B | 30 December 2022 |
| | | | | IN | 202017006368 | A | 02 October 2020 |
| US | 2021013901 | A1 | 14 January 2021 | US | 2022337268 | A1 | 20 October 2022 |
| | | | | WO | 2018171043 | A1 | 27 September 2018 |
| | | | | US | 11368169 | B2 | 21 June 2022 |
| | | | | CA | 3094841 | A1 | 27 September 2018 |
| | | | | CA | 3094841 | C | 02 May 2023 |
| | | | | CN | 108631925 | A | 09 October 2018 |
| | | | | SG | 11202009379 | A1 | 29 October 2020 |
| | | | | CN | 108631925 | B | 03 May 2022 |
| | | | | CN | 115065368 | A | 16 September 2022 |

Form PCT/ISA/210 (patent family annex) (July 2022)